# EUROPÄISCHE PATENTSCHRIFT

(11) **EP 3 410 473 B1**
(45) Veröffentlichungstag und Bekanntmachung des Hinweises auf die Patenterteilung: **24.02.2021**
(21) Anmeldenummer: 17173332.2
(22) Anmeldetag: 30.05.2017
(51) Int. Cl.: H01L 23/373, H01L 21/78, H05K 1/03, H05K 3/00, H01L 21/67, B28D 5/00

(54) **ANORDNUNG UND VERFAHREN ZUM VEREINZELN VON SUBSTRATEN**
APPARATUS AND METHOD FOR DIVIDING SUBSTRATES
APPAREIL ET PROCÉDÉ POUR SÉPARATION DE SUBSTRATS

(43) Veröffentlichungstag der Anmeldung: 05.12.2018
(73) Patentinhaber: Infineon Technologies AG, 85579 Neubiberg (DE)
(72) Erfinder: Mücke, Achim, 59597 Erwitte (DE); Gerke, Stefan, 59519 Möhnesee (DE)
(74) Vertreter: Westphal, Mussgnug & Partner Patentanwälte mbB

(56) Entgegenhaltungen:
- DE-A1-102013 105 528
- JP-A- H0 740 296
- JP-A- H0 919 918
- JP-A- H11 192 616
- JP-A- 2002 011 698
- JP-A- 2008 308 368
- US-A- 4 865 241
- US-A1- 2005 101 052
- US-A1- 2014 026 408

## Beschreibung

Die vorliegende Erfindung betrifft eine Anordnung und ein Verfahren zum Vereinzeln von Substraten.

Substrate, wie beispielsweise Direct-Copper-Bonding-Substrate (DCB-Substrate), kommen häufig in Leistungselektronik-Modulen zum Einsatz. Leistungselektronik-Module kommen zum Beispiel in Antriebssteuerungen von Maschinen und Elektrofahrzeugen, in Automotive-Komponenten oder in der Energietechnik zum Einsatz. Die für Leistungselektronik-Module verwendeten Substrate sind oft Keramiksubstrate welche beispielsweise Al₂O₃ oder AlN als Isolierungsschicht aufweisen. Auf beiden Seiten der Isolierungsschicht sind metallische Schichten, wie beispielsweise Kupferschichten (Cu), aufgebracht. Bei der Fertigung werden dabei meist mehrere Substrate (Schaltungen) auf einer so genannten Großkarte hergestellt. Somit sind während der Fertigung mehrere Substrate miteinander verbunden, welche anschließend vereinzelt werden. Die Vereinzelung kann beispielsweise durch (mechanische) Brechverfahren, Sägen (z.B. Diamantsägen), Laser- oder Wasserstrahlschneiden erfolgen. Die Großkarte muss beim (mechanischen) Brechen meist in mehreren aufeinanderfolgenden Brechvorgängen an verschiedenen Bruchkanten gebrochen werden, um alle darauf befindlichen Substrate zu vereinzeln. Zwischen den einzelnen Brechvorgängen ist es dabei erforderlich die Großkarte entsprechend umzulegen. Beim Umlegen muss die Großkarte durch geeignete Greifvorrichtungen aufgenommen werden, was zu Beschädigungen, wie z.B. Kratzer in der Substratoberfläche oder ungewollten Keramikbrüchen, führen kann. Beim Umlegen können Substrate auch herabfallen und dabei zerbrechen. Zudem ist das Risiko für Verunreinigungen auf der Oberfläche erhöht. Auch beim Sägen von Substraten kann es leicht zu Verunreinigungen kommen. Zudem ist die Vereinzelung durch Sägen sehr zeitintensiv und hat einen hohen Werkzeugverschleiß (Abnutzung der Sägeblätter) und somit erhöhte Kosten zur Folge.

Das Dokument US 4,865,241 A offenbart eine Vorrichtung zum Brechen keramischer Substrate. Das zu unterteilende Substrat wird mittels zweier starren Formen die jeweils einen kreisförmigen Querschnitt mit sich voneinander unterscheidenden Radien aufweisen einer vorgegebenen starren Verformung unterworfen. Die Krümmungsmittelpunkte der kreisförmigen Querschnitte fallen zusammen, wenn sich die Stempel in ihrer endgültigen Position befinden.

Das Dokument US 2014/0026408 A1 offenbart eine Vorrichtung, die zum Brechen einer Leiterplatte geeignet ist. Die Vorrichtung umfasst: eine Bodenplatte, die eine Vorderseite und eine Rückseite gegenüber der Vorderseite umfasst; einen Brechmechanismus, der an der Vorderseite der Bodenplatte angeordnet ist und eine Befestigungsplatte und eine der Befestigungsplatte benachbarte Klappplatte aufweist, wobei eine Achsenlinie zwischen der Befestigungsplatte und der Klappplatte definiert ist, wobei die Klappplatte entlang der Achsenlinie geklappt ist, und die Leiterplatte wird auf die Befestigungsplatte und die Klappplatte platziert; eine erste Platte mit einer ersten Bewegungsvorrichtung, die an einer Seite der Befestigungsplatte angeordnet ist, um die Schaltungsplatte durch die erste Bewegungsvorrichtung an der Befestigungsplatte zu befestigen; und eine zweite Platte, die eine zweite Bewegungsvorrichtung enthält, die an einer Seite der Klappplatte angeordnet ist, um die Leiterplatte durch die zweite Bewegungsvorrichtung an der Klappplatte zu befestigen.

Das Dokument JPH 11 192 616-A1 zeigt eine weitere Anordnung zum Vereinzeln von Keramiksubstraten.

Aufgabe der Erfindung ist es, eine Anordnung und ein Verfahren zum Vereinzeln von Substraten bereitzustellen, bei welcher die oben genannten Nachteile vermieden werden.

Diese Aufgabe wird durch eine Anordnung gemäß Anspruch 1 und ein Verfahren gemäß Anspruch 14 gelöst. Ausgestaltungen und Weiterbildungen des Erfindungsgedankens sind Gegenstand von abhängigen Ansprüchen.

Eine Anordnung zum Vereinzeln von Substraten weist eine Auflagefläche auf die dazu ausgebildet ist, eine Substrat-Karte mit einer ersten Oberfläche und einer der ersten Oberfläche gegenüberliegenden zweiten Oberfläche derart aufzunehmen, dass die Substrat-Karte mit ihrer zweiten Oberfläche zumindest teilweise auf der Auflagefläche aufliegt. Die Anordnung weist weiterhin eine erste Haltevorrichtung und eine erste Brechvorrichtung auf. Die erste Haltevorrichtung ist dazu ausgebildet, eine auf der Auflagefläche angeordnete Substrat-Karte während eines ersten Brechvorgangs auf der Auflagefläche zu halten. Die erste Haltevorrichtung ist weiter dazu ausgebildet, während des ersten Brechvorgangs auf einen ersten Haltebereich der Substrat-Karte eine erste Haltekraft auszuüben. Die erste Brechvorrichtung ist dazu ausgebildet, während des ersten Brechvorgangs auf einen ersten Brechbereich der Substrat-Karte eine erste Brechkraft auszuüben um die Substrat-Karte teilweise zu vereinzeln. Die Anordnung weist weiterhin eine zweite Haltevorrichtung und eine zweite Brechvorrichtung auf. Die zweite Haltevorrichtung ist dazu ausgebildet, die nach dem ersten Brechvorgang teilweise vereinzelte Substrat-Karte während eines zweiten Brechvorgangs auf der Auflagefläche zu halten. Die zweite Haltevorrichtung ist weiter dazu ausgebildet, während des zweiten Brechvorgangs auf einen zweiten Haltebereich der Substrat-Karte eine zweite Haltekraft auszuüben. Die zweite Brechvorrichtung ist dazu ausgebildet, während des zweiten Brechvorgangs auf einen zweiten Brechbereich der Substrat-Karte eine zweite Brechkraft auszuüben um die Substrat-Karte weiter zu vereinzeln.

Ein Verfahren zum Vereinzeln von Substraten weist auf: Auflegen einer Substrat-Karte auf eine Auflagefläche, wobei die Substrat-Karte eine erste Oberfläche und eine der ersten Oberfläche gegenüberliegende zweite Oberfläche aufweist, und wobei die Substrat-Karte derart aufgelegt wird, dass sie mit ihrer zweiten Oberfläche zumindest teilweise auf der Auflagefläche aufliegt; Ausüben einer ersten Haltekraft auf einen ersten Haltebereich der Substrat-Karte während eines ersten Brechvorgangs mittels einer ersten Haltevorrichtung die dazu ausgebildet ist, die auf der Auflagefläche angeordnete Substrat-Karte während eines ersten Brechvorgangs auf der Auflagefläche zu halten; Ausüben einer ersten Brechkraft auf einen ersten Brechbereich der Substrat-Karte mittels einer ersten Brechvorrichtung die dazu ausgebildet ist, während des ersten Brechvorgangs die Substrat-Karte teilweise zu vereinzeln; Ausüben einer zweiten Haltekraft auf einen zweiten Haltebereich der Substrat-Karte während eines zweiten Brechvorgangs mittels einer zweiten Haltevorrichtung die dazu ausgebildet ist, die nach dem ersten Brechvorgang teilweise vereinzelte Substrat-Karte während eines zweiten Brechvorgangs auf der Auflagefläche zu halten; und Ausüben einer zweiten Brechkraft auf einen zweiten Brechbereich der Substrat-Karte mittels einer zweiten Brechvorrichtung die dazu ausgebildet ist, während des zweiten Brechvorgangs die Substrat-Karte weiter zu vereinzeln.

Beispiele werden im Weiteren unter Bezugnahme auf die Figuren beschrieben. Die Figuren dienen dazu, bestimmte Grundsätze darzustellen, so dass nur solche Aspekte dargestellt werden, welche für das Verständnis dieser Grundsätze erforderlich sind. Die Figuren sind nicht maßstabsgetreu. In den Figuren bezeichnen gleiche Bezugszeichen gleiche Merkmale.
Figur 1 zeigt beispielhaft eine Substrat-Karte mit mehreren Substraten.
Figur 2, umfassend die Figuren 2A und 2B, zeigt ein Verfahren zum Entfernen von Randbereichen einer Substrat-Karte.
Figur 3 zeigt ein Beispiel einer Anordnung zum Entfernen von Randbereichen einer Substrat-Karte gemäß einer Ausführungsform der Erfindung.
Figur 4, umfassend die Figuren 4A und 4B, zeigt ein Beispiel einer Vorrichtung zum Vereinzeln von Substraten aus einer Substrat-Karte gemäß einer Ausführungsform der Erfindung.
Figur 5, umfassend die Figuren 5A bis 5C, zeigt beispielhaft verschiedene Ausführungsformen eines Teilbereiches einer Haltevorrichtung.
Figur 6 zeigt ein weiteres Beispiel einer Vorrichtung zum Vereinzeln von Substraten aus einer Substrat-Karte gemäß einer Ausführungsform der Erfindung.
Figur 7 zeigt ein weiteres Beispiel einer Vorrichtung zum Vereinzeln von Substraten aus einer Substrat-Karte gemäß einer Ausführungsform der Erfindung.
Figur 8 zeigt ein weiteres Beispiel einer Vorrichtung zum Vereinzeln von Substraten aus einer Substrat-Karte gemäß einer Ausführungsform der Erfindung.
Figur 9 zeigt die Anordnung aus Figur 8 während eines Brechvorganges zum Entfernen von Randbereichen.
Figur 10 zeigt die Anordnung aus Figur 9 in größerem Detail.
Figur 11 zeigt die Anordnung aus Figur 8 während eines ersten Brechvorganges zum Vereinzeln der Substrate.
Figur 12 zeigt einen Querschnitt der Anordnung aus Figur 11 während des ersten Brechvorganges.
Figur 13 zeigt die Anordnung aus Figur 8 während eines zweiten Brechvorganges zum Vereinzeln der Substrate.
Figur 14 zeigt einen Querschnitt der Anordnung aus Figur 13 während des zweiten Brechvorganges.
Figur 15, umfassend die Figuren 15A und 15B, zeigt beispielhaft dritte Haltebereiche und dritte Brechbereiche während des Brechvorganges zum Entfernen der Randbereiche.
Figur 16, umfassend die Figuren 16A und 16B, zeigt beispielhaft erste Haltebereiche und erste Brechbereiche während des ersten Brechvorgangs.
Figur 17, umfassend die Figuren 17A und 17B, zeigt beispielhaft zweite Haltebereiche und zweite Brechbereiche während des zweiten Brechvorgangs.

In der folgenden detaillierten Beschreibung wird auf die beigefügten Figuren Bezug genommen. Die Figuren bilden einen Teil der Beschreibung und zeigen zur Veranschaulichung bestimmte Ausführungsformen, in welchen die Erfindung Verwendung finden kann. Es versteht sich, dass die Merkmale der beschriebenen Ausführungsformen miteinander kombiniert werden können, sofern nicht anders angegeben. Die Bezeichnungen "erste/r", "zweite/r" und "dritte/r" in Bezug auf Komponenten der Anordnung werden lediglich verwendet um zusammengehörige Komponenten die in den gleichen Brechvorgängen verwendet werden entsprechend zu kennzeichnen. Die Bezeichnungen legen jedoch keine Reihenfolge fest, in welcher die einzelnen Brechvorgänge durchgeführt werden und in welcher die Komponenten beim Vereinzeln der Substrate zum Einsatz kommen.

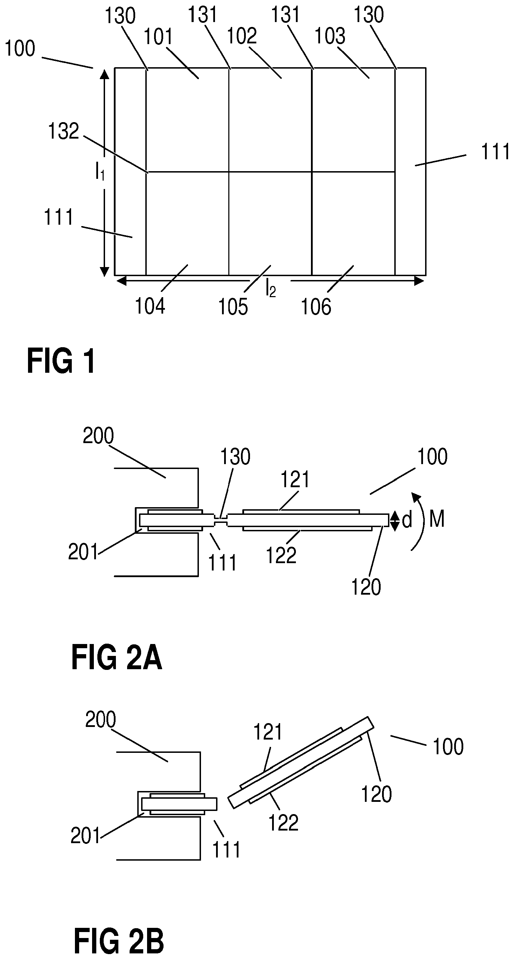

Figur 1 zeigt beispielhaft eine Draufsicht auf eine Substrat-Karte 100, oft auch als Großkarte bezeichnet. Die Substrat-Karte 100 weist eine Vielzahl von einzelnen Substraten 101, 102, 103, 104, 105, 106 auf. Die in Figur 1 dargestellte Substrat-Karte 100 weist beispielsweise sechs einzelne Substrate 101, 102, 103, 104, 105, 106 auf. Dies ist jedoch lediglich ein Beispiel. Die Substrat-Karte 100 kann beispielsweise auch weniger als sechs Substrate, z.B. lediglich drei einzelne Substrate, oder mehr als sechs einzelne Substrate aufweisen. Gemäß einem Beispiel weist die Substrat-Karte 100 eine gerade Anzahl n einzelner Substrate auf, mit n ≥ 4. Die Substrat-Karte 100 kann beispielsweise eine quadratische oder rechteckige Form aufweisen. Dies sind jedoch lediglich Beispiele. Auch andere Formen, wie beispielsweise eine runde Form, sind grundsätzlich möglich. Die einzelnen Substrate 101, 102, 103, 104, 105, 106 können beispielsweise eine quadratische oder rechteckige Form aufweisen.

In dem in Figur 1 dargestellten Beispiel weist die Substrat-Karte 100 eine erste Länge l₁ in einer ersten Richtung und eine zweite Länge l₂ in einer zweiten Richtung auf. Die erste Länge l₁ kann beispielsweise ca. 40mm betragen und die zweite Länge l₂ kann beispielsweise ca. 53mm betragen. Gemäß einem Beispiel weisen die einzelnen Substrate 101, 102, 203, 104, 105, 106 jeweils identische Abmessungen auf. Jedes der einzelnen Substrate 101, 102, 203, 104, 105, 106 kann beispielsweise eine Länge von 20mm in der ersten Richtung und eine Länge von 12mm in der zweiten Richtung aufweisen. Dies ist jedoch lediglich ein Beispiel. Andere Maße der Substrat-Karte 100 und der einzelnen Substrate 101, 102, 103, 104, 105, 106 sind ebenfalls möglich. Die einzelnen Substrate 101, 102, 103, 104, 105, 106 bilden gemäß einem Beispiel die gesamte Fläche der Substrat-Karte 100. Gemäß einem weiteren Beispiel bilden die einzelnen Substrate 101, 102, 103, 104, 105, 106 hingegen nicht die gesamte Fläche der Substrat-Karte 100. Beispielsweise können an einem oder an mehreren Rändern der Substrat-Karte 100 zusätzliche Randbereiche 111 vorhanden sein. Solche Randbereiche 111 können beispielsweise die Handhabung der Substrat-Karte 100 vor dem Vereinzeln der Substrate 101, 102, 103, 104, 105, 106 erleichtern. Beispielsweise kann die Substrat-Karte 100 vor dem Vereinzeln nur in den Randbereichen 111 gegriffen werden, um die Substrat-Karte 100 beispielsweise zwischen zwei Fertigungsmaschinen zu transportieren. Dadurch können Beschädigungen der Substrate 101, 102, 103, 104, 105, 106 vermieden werden.

Figur 2 zeigt schematisch eine Seitenansicht einer Substrat-Karte 100. Die Substrat-Karte 100 kann, wie in Figur 2 schematisch dargestellt, beispielsweise eine elektrisch isolierende Schicht 120 aufweisen. Die elektrisch isolierende Schicht 120 kann beispielsweise ein Keramikmaterial aufweisen wie z.B. Al₂O₃, Al₂TiO₅, ZrO₂, AlN, Si₃N₄ oder SSiC. Dies sind jedoch nur Beispiele. Andere keramische oder elektrisch isolierende Materialien sind ebenfalls möglich. Auf einer ersten Oberfläche der elektrisch isolierenden Schicht 120 ist eine erste elektrisch leitende Schicht 121 angeordnet und auf einer zweiten, der ersten gegenüberliegenden Seite ist eine zweite elektrisch leitende Schicht 122 angeordnet. Die erste elektrisch leitende Schicht 121 kann die erste Oberfläche der elektrisch isolierenden Schicht 120 zumindest teilweise bedecken und die zweite elektrisch leitende Schicht 122 kann die zweite Oberfläche der elektrisch isolierenden Schicht 120 zumindest teilweise bedecken. Die elektrisch leitenden Schichten 121, 122 können ein Metall oder eine Metalllegierung aufweisen, wie beispielsweise Cu oder Al. Dabei können die elektrisch leitenden Schichten 121, 122 jeweils das selbe Metall oder die selbe Metalllegierung aufweisen oder sie können ein unterschiedliches Metall oder eine unterschiedliche Metalllegierung aufweisen. Die Substrate 101, 102, 103, 104, 105, 106 können beispielsweise Direct-Copper-Bonded-Substrate (DCB-Substrate) oder Insulated-Metal-Substrate (IMS-Substrate) sein. Auf den elektrisch leitenden Schichten 121, 122 können elektronische Bauelemente angeordnet werden (nicht dargestellt). Um entsprechende Verbindungen zwischen verschiedenen elektronischen Bauelementen eines Substrates 101, 102, 103, 104, 105, 106 herzustellen, können die elektrisch leitenden Schichten 121, 122 strukturiert sein (nicht dargestellt). Elektrische Verbindungen zwischen den einzelnen Substraten 101, 102, 103, 104, 105, 106 bestehen dabei nicht. Das heißt, die elektrisch leitenden Schichten 121, 122 sind zumindest in den Randbereichen der einzelnen Substrate 101, 102, 103, 104, 105, 106 unterbrochen.

Die Substrate 101, 102, 103, 104, 105, 106 können beispielsweise durch Sägen oder Laserschneiden vereinzelt werden. Die genannten Verfahren weisen jedoch verschiedenste Nachteile auf. Die Substrat-Karte 100 kann beispielsweise zum Vereinzeln der Substrate 101, 102, 103, 104, 105, 106 auch gebrochen werden. Hierfür können Schwächungsstellen (Schwächungslinien) an den vorgesehenen Bruchkanten 130 vorgesehen sein, welche eine Sollbruchstelle darstellen an welcher die Substrat-Karte 100 gezielt brechen soll. Schwächungsstellen können beispielsweise durch Lochungen, Ritzungen oder Materialschwächungen (z.B. thermische Laserverfahren) erzeugt werden. Schwächungen können dabei von einer Seite der Substrat-Karte 100 oder von beiden Seiten der Substrat-Karte 100 erzeugt werden. Schwächungsstellen können jedoch nicht nur an den Bruchkanten 130 zwischen den einzelnen Substraten 101, 102, 103, 104, 105, 106 vorgesehen sein, sondern auch an den Bruchkanten 130 zwischen Substraten 101, 102, 103, 104, 105, 106 und Randbereichen 111. Eine solche Bruchkante 130 ist in Figur 2A schematisch dargestellt. Die Substrat-Karte 100 weist an der Stelle der Bruchkante 130 eine geringere Dicke auf. Die Substrat-Karte 100 weist beispielsweise eine erste Dicke d in einer Richtung senkrecht zu der ersten und zweiten Oberfläche auf. Im Bereich einer Bruchkante 130 kann diese Dicke d reduziert sein. Beispielsweise weisen die erste elektrisch leitende Schicht 121 und die zweite elektrisch leitende Schicht 122 im Bereich von Bruchkanten 130 Unterbrechungen auf. Weiterhin kann die Dicke der elektrisch isolierenden Schicht 120 im Bereich von Bruchkanten 130 zumindest abschnittsweise reduziert sein. Die Dicke d der Substrat-Karte 100 kann beispielsweise 1000µm, 600µm, 400µm oder 200µm betragen. Im Bereich von Bruchkanten kann die Dicke d beispielsweise und mindestens 10%, mindestens 25% oder mindestens 50% reduziert sein. Dies sind jedoch nur Beispiele. Jegliche andere Dicken d der Substrat-Karte 100 und der Bruchkanten 130 sind möglich.

Bei einem bekannten Verfahren zum Entfernen der Randbereiche 111 kommt ein Klotz 200 mit einem Schlitz 201 zum Einsatz. Ein solcher Klotz ist in Figur 2 schematisch dargestellt, wobei Figur 2A die Substrat-Karte 100 vor dem Brechen und Figur 2B die Substrat-Karte 100 nach dem Brechen zeigt. Der Schlitz 201 kann eine Dicke aufweisen, die etwas größer ist als die Dicke d der Substrat-Karte 100 mit der elektrisch isolierenden Schicht 120 und den elektrisch leitenden Schichten 121, 122. So kann der Randbereich 111 in den Schlitz 201 eingeführt werden. Der Klotz 200 ist unbeweglich und hält somit den Randbereich 111 fest, während auf die Substrat-Karte 100 ein (Biege-)Moment M ausgeübt wird. Im Bereich der Bruchkante 130 (Sollbruchstelle) bricht somit die Substrat-Karte 100 und es wird der Randbereich 111 vom Rest der Substrat-Karte 100 getrennt. Das (Biege-)Moment M auf die Substrat-Karte 100 kann beispielsweise manuell ausgeübt werden. Es ist jedoch auch möglich diesen Schritt maschinell auszuführen. Dieser Vorgang zur Entfernung der Randbereiche kann jedoch Probleme verursachen. Beispielsweise kann es dabei vorkommen, dass die Substrat-Karte nicht genau an der Bruchkante 130 bricht. Zudem kann der Effekt der Muschelbildung auftreten oder es kann zu Haarrissen kommen. Gerade kleinere Substrate 101, 102, 103, 104, 105, 106 bzw. Substrat-Karten 100 (z.B. l₁ < 30mm und l₂ < 60mm) können wegen der geringen Größe schlecht durch Menschen oder Maschinen greifbar sein, was zu Schäden an den Substraten 101, 102, 103, 104, 105, 106 oder zu Verzögerungen im Vereinzelungsprozess führen kann.

Weist eine Substrat-Karte 100 mehr als einen Randbereich 111 auf, wie beispielsweise in Figur 1 dargestellt, wird die Substrat-Karte 100 nach dem Entfernen des Randbereiches 11 auf der ersten Seite gedreht um die Randbereiche 111 auch auf den anderen Seiten auf die selbe Art und Weise mit Hilfe des unbeweglichen Klotzes 200 zu entfernen.

Nach dem Entfernen der Randbereiche 111 wird die Substrat-Karte 100 dann in eine zweite, unterschiedliche Bearbeitungsmaschine gelegt, um nun auch die Substrate 101, 102, 103, 104, 105, 106 zu vereinzeln. Dabei sind zum Vereinzeln der Substrate 101, 102, 103, 104, 105, 106 mehrere Brechvorgänge erforderlich. Bei der in Figur 1 dargestellten Substrat-Karte 100 mit sechs einzelnen Substraten 101, 102, 103, 104, 105, 106 sind beispielsweise neben zwei Brechvorgängen zum Entfernen der Randbereiche 111 drei weitere Brechvorgänge zum Vereinzeln der Substrate 101, 102, 103, 104, 105, 106 erforderlich. Zwischen jeweils zwei aufeinanderfolgenden Brechvorgängen muss die Substrat-Karte 100 oder müssen die bereits teilweise vereinzelten Substrate 101, 102, 103, 104, 105, 106 gegriffen und umgelegt werden um anschließend den nächsten Brechvorgang durchführen zu können. Jedes Mal wenn die Substrat-Karte 100 erneut gegriffen und umgelegt werden muss besteht das Risiko von Beschädigungen auf den Substrat-Oberflächen.

Die vorliegende Erfindung sieht daher vor alle notwendigen Brechvorgänge in ein und derselben Vorrichtung vorzunehmen, so dass ein Greifen und Umlegen der Substrat-Karte 100 zwischen den einzelnen Brechvorgängen nicht erforderlich ist. Weiterhin können mit der hierin beschriebenen Anordnung auch mehrere Brechvorgänge in einem einzigen Schritt gleichzeitig durchgeführt werden.

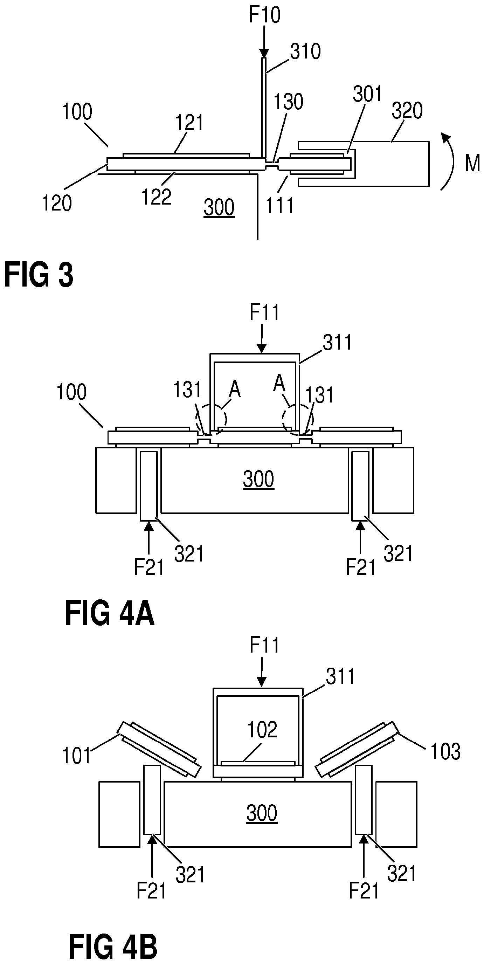

Bezugnehmend auf Figur 3 können, sofern vorhanden, in einem Bearbeitungsschritt die Randbereiche 111 entfernt werden. Dieser Schritt kann beispielsweise vor dem Vereinzeln der Substrate 101, 102, 103, 104, 105, 106 erfolgen. Grundsätzlich ist es jedoch auch möglich die Randbereiche 111 erst nach dem Vereinzeln oder zwischen zwei Vereinzelungsschritten zu entfernen. Die Substrat-Karte 100 liegt mit ihrer zweiten Oberfläche (im Weiteren auch als Unterseite bezeichnet) auf einer Auflagefläche 300 auf. Dabei ragen eventuell vorhandene Randbereiche 111 zumindest teilweise über die Auflagefläche 300 hinaus. In Figur 3 ist dies beispielhaft für eine Seite der Substrat-Karte 100 dargestellt. Jedoch kann die Substrat-Karte 100 wie bereits beschrieben an mehreren Seiten Randbereiche 111 aufweisen, welche jeweils auf der entsprechenden Seite über die Auflagefläche 300 hinausragen.

Eine dritte Haltevorrichtung 310 kann die Substrat-Karte 100 auf der Auflagefläche fixieren. Beispielsweise kann die dritte Haltevorrichtung 310 eine dritte Haltekraft F10 auf die erste Oberfläche (im Folgenden auch als Oberseite bezeichnet) der Substrat-Karte 100 ausüben. Es ist jedoch nicht zwangsläufig erforderlich, dass die dritte Haltevorrichtung 310 aktiv eine Haltekraft F10 auf die Substrat-Karte 100 ausübt. Vielmehr kann die dritte Haltevorrichtung 310 auch derart über der Oberseite der Substrat-Karte 100 angeordnet werden, dass sie zwar aktiv keine Kraft auf diese ausübt, dass jedoch die Substrat-Karte 100 auf der Auflagefläche 300 gehalten wird, wenn der Randbereich 111 entfernt wird. Beispielsweise kann die Substrat-Karte 100 beim Entfernen des Randbereiches 111 beim Ausüben einer Brechkraft oder eines Momentes auf die Substrat-Karte 100 angehoben und von unten gegen die Haltevorrichtung 310 gedrückt werden. Eine dritte Brechvorrichtung 320 ist dazu ausgebildet ein Moment M auf den Randbereich 111 auszuüben. Die Brechvorrichtung 320 kann beispielsweise ein bewegliches Griffstück 320 aufweisen. Das bewegliche Griffstück 320 kann einen Schlitz 301 aufweisen, der dazu ausgebildet ist den Randbereich 111 aufzunehmen. Eine Dicke bzw. Höhe des Schlitzes 301 kann geringfügig größer sein als die Dicke d der Substrat-Karte 100 (vgl. Figur 2). So kann das Griffstück 320 mit dem Schlitz 301 leicht über den Randbereich 111 der Substrat-Karte 100 geschoben werden. Wird auf das bewegliche Griffstück 320 anschließend ein Moment M ausgeübt, bewegt sich der Randbereich 111 mit der Brechvorrichtung 320 mit, da er in dem Schlitz 301 nur ein geringes Spiel von beispielsweise zwischen 0,02 und 1mm aufweist. Im Bereich der Bruchkante 130 bricht dann der Randbereich 111 von der Substrat-Karte 100 ab.

Die dritte Haltevorrichtung 310 kann (aktiv oder passiv) in einem dritten Haltebereich auf der Oberseite der Substrat-Karte 100 eine Haltekraft F10 auf die Substrat-Karte 100 ausüben, so dass die Substrat-Karte 100 während des Brechvorgangs auf der Auflagefläche 300, bzw. zwischen der Auflagefläche 300 und der Haltevorrichtung 310 gehalten wird. Die dritte Haltevorrichtung 310 kann, wie in Figur 3 beispielhaft dargestellt, eine schmale Leiste aufweisen. Diese Leiste kann die Substrat-Karte 100 beispielsweise entlang der entsprechenden Bruchkante 130 halten. Der dritte Haltebereich, also der Bereich in welchem die dritte Haltevorrichtung 310 und die Substrat-Karte 100 in Berührung kommen und welcher einer Haltekraft ausgesetzt ist, kann somit ein schmaler, länglicher Bereich sein, welcher entlang der dritten Bruchkante 130 zwischen dem Randbereich 111 und den benachbarten Substraten (z.B. 101, 104) verläuft. Die Länge der dritten Haltevorrichtung 310 kann beispielsweise der Länge der Substrat-Karte 100 in der entsprechenden Richtung entsprechen (z.B. Länge l₁). Die Breite der dritten Haltevorrichtung 310 kann beispielsweise weniger als 1mm, 1mm oder wenige Millimeter betragen. Es ist jedoch auch möglich, dass die Haltevorrichtung 310 die Substrate 101, 102, 103, 104, 105, 106 komplett bedeckt, die Substrat-Karte 100 also flächig niedergehalten wird. Entscheidend ist, dass die Substrat-Karte 100 während des Brechvorgangs ausreichend gehalten wird und keine Schäden an der Substrat-Karte 100 entstehen können. Der dritte Haltebereich verläuft somit auf einer ersten Seite entlang der entsprechenden Bruchkante 130. Der Abstand zwischen dem dritten Haltebereich und der Bruchkante 130 kann beispielsweise 0mm betragen, der Abstand kann jedoch beispielsweise auch zwischen 0mm und 1mm, zwischen 0mm und 5mm oder zwischen 0mm und 10mm betragen. Je weiter entfernt der dritte Haltebereich von der Bruchkante 130 verläuft, umso größer ist jedoch die Gefahr, dass ungewollte Schäden an der Substrat-Karte 100 auftreten.

Besitzt die Substrat-Karte 100 auf mehr als einer Seite einen Randbereich 111, dann ist es grundsätzlich möglich, die Randbereiche 111 auf allen Seiten gleichzeitig zu entfernen. Es werden hierfür auf allen Seiten mit Randbereich 111 Brechvorrichtungen 320 angesetzt und die Randbereiche 111 abgebrochen. Es ist jedoch auch möglich ein und dieselbe Brechvorrichtung 320 für jede der Seiten zu verwenden. Die verschiedenen Randbereiche 111 würden dann nacheinander entfernt werden. Ebenso ist es beispielsweise möglich zwei gegenüberliegende Randbereiche 111 gleichzeitig zu entfernen, und anschließend die Randbereiche 111 der verbleibenden Seiten, welche sich ebenfalls gegenüber liegen, zu entfernen. In jedem Fall bleibt die Substrat-Karte 100 während dem Entfernen der Randbereiche 111 auf der Auflagefläche 300 liegen und wird in ihrer Position nicht verändert. Die dritte Haltevorrichtung 310 hält die Substrat-Karte 100 entsprechend der Anzahl der Randbereiche entlang der entsprechenden Bruchkanten 130 auf der Auflagefläche 300.

Figur 4 zeigt die Vorrichtung zum Vereinzeln von Substraten 101, 102, 103, 104, 105, 106 während eines folgenden Vereinzelungsschritts. Bezugnehmend auf Figur 4A weist die Vorrichtung eine erste Haltevorrichtung 311 und eine erste Brechvorrichtung 321 auf. Die erste Haltevorrichtung 311 kann während eines ersten Brechvorgangs zum Vereinzeln der Substrate 101, 102, 103, 104, 105, 106 die Substrat-Karte 100, bzw. einen ersten Teil der Substrat-Karte 100 auf der Auflagefläche 300 halten. Der erste Teil kann beispielsweise eines oder mehrere der einzelnen Substrate 101, 102, 103, 104, 105, 106 aufweisen. Im vorliegenden Beispiel weist der erste Teil beispielsweise das zweite Substrat 102 und das fünfte Substrat 105 auf, wobei das fünfte Substrat 105 in der Ansicht in Figur 4 nicht zu sehen ist. Während der erste Teil der Substrat-Karte 100 auf der Auflagefläche 300 gehalten wird, wird auf einen zweiten Teil der Substrat-Karte 100 eine erste Brechkraft F21 ausgeübt. So kann der erste Teil der Substrat-Karte 100 vom zweiten Teil der Substrat-Karte 100 getrennt werden. Der zweite Teil kann ein zusammenhängender Teil sein oder kann, wie in Figur 4 dargestellt, aus mehreren Teilbereichen bestehen. Im vorliegenden Beispiel weist der zweite Teil beispielsweise zwei Teilbereiche auf, nämlich einen ersten Teilbereich mit dem ersten Substrat 101 und dem vierten Substrat 104, wobei das vierte Substrat 104 in der Ansicht in Figur 4 nicht zu sehen ist, und einen zweiten Teilbereich mit dem dritten Substrat 103 und dem sechsten Substrat 106, wobei das sechste Substrat 106 in der Ansicht in Figur 4 nicht zu sehen ist. Der zweite Teil der Substrat-Karte 100 liegt somit in der Mitte zwischen dem ersten Teilbereich und dem zweiten Teilbereich.

Der erste Teil der Substrat-Karte 100 wird von dem wenigstens einen Teilbereich durch wenigstens eine erste Bruchkante 131 getrennt. Wenn während des Brechvorgangs eine Brechkraft F21 auf jeden der Teilbereiche ausgeübt wird, kann der erste Teil von dem zweiten Teil getrennt werden indem die Substrat-Karte 100 an den entsprechenden ersten Bruchkanten 131 bricht.

Die erste Brechvorrichtung 321 kann beispielsweise eine oder mehrere Brechleisten aufweisen, wie in Figur 4 dargestellt. Die Anzahl der Brechleisten kann beispielsweise der Anzahl der ersten Bruchkanten 131 entsprechen. Die Auflagefläche 300 kann Aussparungen aufweisen, in welchen die erste Brechvorrichtung 321 angeordnet ist. Durch Anheben der Brechvorrichtung 321, z.B. Brechleisten, kann eine Brechkraft F21 auf die Unterseite der Substrat-Karte 100 im zweiten Teil der Substrat-Karte 100 ausgeübt werden, so dass der zweite Teil angehoben wird und an den ersten Bruchkanten 131 vom ersten Teil abbricht.

Die erste Haltevorrichtung 311 kann eine Haltekraft F11 auf den ersten Teil der Substrat-Karte 100 entlang der entsprechenden ersten Bruchkanten 131 ausüben. Hierfür kann die erste Haltevorrichtung 311 eine entsprechende Anzahl an Halteleisten aufweisen. In dem Beispiel aus Figur 4 findet ein Brechvorgang entlang von zwei Bruchkanten 131 statt. Daher kann die erste Haltevorrichtung 311 in diesem Beispiel zwei Halteleisten aufweisen die jeweils entlang der ersten Bruchkanten 131 verlaufen. Jede Halteleiste kann in einer ersten Richtung eine Länge aufweisen, welche im Wesentlichen der Länge der Substrat-Karte 100 in der selben Richtung entspricht. Eine Breite der Halteleisten kann weniger als 1mm, 1mm oder mehrere Millimeter betragen. Dies ist jedoch nur ein Beispiel. Die erste Haltevorrichtung 311 kann den ersten Teil auch flächig auf der Auflagefläche 300 halten. Beispielsweise kann die Größe der Haltevorrichtung 311 der Größe des ersten Teils entsprechen und diesen somit vollständig bedecken. Entscheidend ist dabei, dass der erste Teil der Substrat-Karte 100 während des Brechvorgangs ausreichend gehalten wird und möglichst keine Schäden an dem ersten Teil oder dem zweiten Teil der Substrat-Karte 100 entstehen.

Der erste Haltebereich in welchem die erste Haltevorrichtung 311 mit der Substrat-Karte 100 in Kontakt kommt, verläuft somit auf einer ersten Seite entlang jeder der ersten Bruchkanten 131. Der erste Haltebereich kann ein zusammenhängender Bereich sein oder kann mehrere Teilbereiche aufweisen. Der Abstand zwischen dem ersten Haltebereich und einer ersten Bruchkante 131 kann beispielsweise 0mm betragen, der Abstand kann jedoch beispielsweise auch zwischen 0mm und 1mm, zwischen 0mm und 5mm oder zwischen 0mm und 10mm betragen. Je weiter entfernt der erste Haltebereich von einer ersten Bruchkante 131 verläuft, umso größer ist jedoch die Gefahr, dass ungewollte Schäden an der Substrat-Karte 100 auftreten.

Um die Beschädigung relevanter Bereiche auf der Substratoberfläche möglichst zu vermeiden, kann die erste Haltevorrichtung 311 die Substrat-Karte 100 beispielsweise nur in solchen Bereichen berühren, in welchen keine elektrisch leitende Schicht 121 auf der elektrisch isolierenden Schicht 120 aufgebracht ist. Dies ist in den Figuren 4 bis 7 beispielhaft dargestellt.

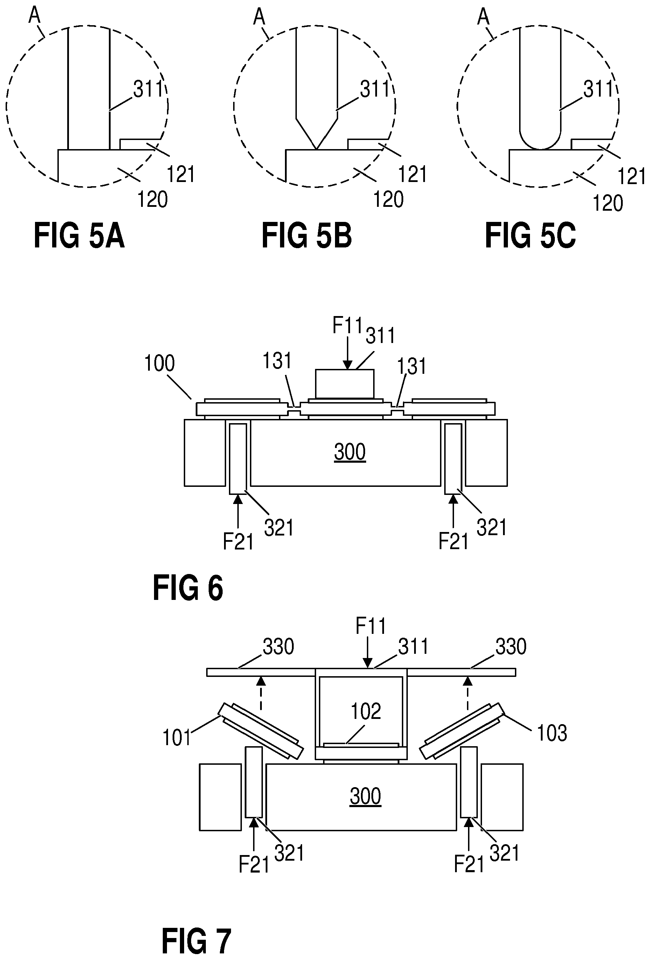

Die Kontaktfläche der Haltevorrichtung 311 mit welcher die erste Haltevorrichtung 311 die Oberseite der Substrat-Karte 100 berührt, kann dabei verschiedene Formen aufweisen. Ein entsprechender Ausschnitt A der ersten Haltevorrichtung 311 aus Figur 4A ist jeweils in den Figuren 5A, 5B und 5C dargestellt. Beispielsweise kann die Kontaktfläche der ersten Haltevorrichtung 311 wie in Figur 5A dargestellt flach sein und flächig auf der Oberseite der Substrat-Karte 100 aufliegen. Der erste Haltebereich kann dadurch eine größere Fläche aufweisen. Wie in Figur 5B beispielhaft dargestellt, kann die Kontaktfläche jedoch auch eine Spitze aufweisen und die Oberseite der Substrat-Karte 100 somit nur in einem sehr schmalen, begrenzten Bereich berühren. Der erste Haltebereich hätte in diesem Fall eine verhältnismäßig kleine Fläche. Wie in Figur 5C dargestellt, kann die Kontaktfläche beispielsweise auch eine gerundete Form aufweisen. Auch in diesem Beispiel würde der erste Haltebereich eine eher kleine Fläche aufweisen. Dies sind jedoch lediglich Beispiele. Jegliche andere Formen der Kontaktfläche, beispielsweise auch unregelmäßige Formen, sind ebenfalls möglich.

Figur 6 zeigt beispielhaft eine flächige erste Haltevorrichtung 311, deren Fläche im Wesentlichen der Fläche des ersten Teils der Substrat-Karte 100 entspricht, wie oben bereits beschrieben. Der erste Haltebereich kann bei einer solchen flächigen Ausführung beispielsweise den ersten Teil der Substrat-Karte 100 gänzlich bedecken. Beispielsweise kann der erste Haltebereich 100%, >95%, >80% oder >70% des ersten Teil der Substrat-Karte 100 bedecken. Bei einer solchen flächigen Ausführung kann die erste Haltevorrichtung 311 an ihrer Unterseite, welche mit der Substrat-Karte 100 in Kontakt kommt, beispielsweise ein plan geschliffenes Material, oder ein elastisches Material, wie z.B. Gummi, insbesondere ESD-Gummi, aufweisen, damit die Substratoberfläche nicht beschädigt wird.

Beim Brechen der Substrat-Karte 100 mittels einer ersten Brechvorrichtung 321 kann es passieren, dass der zweite Teil der Substrat-Karte 100, bzw. die verschiedenen Teilbereiche, von der Auflagefläche 300 springen wenn eine Brechkraft F21 auf die Unterseite des zweiten Teils ausgeübt wird. Der zweite Teil kann dann möglicherweise unkontrolliert umherspringen und dabei beschädigt werden. Um dies zu verhindern kann die Vorrichtung eine Auffangvorrichtung 330 aufweisen. Die Auffangvorrichtung 330 kann während dem Brechvorgang zumindest teilweise über dem zweiten Teil angeordnet sein und ist dazu ausgebildet ein Umherfliegen des zweiten Teils, bzw. der Teilbereiche, zu verhindern. Dies ist beispielhaft in Figur 7 dargestellt. Die Auffangvorrichtung 330 kann beispielsweise mit der ersten Haltevorrichtung 311 verbunden sein. Die Auffangvorrichtung 330 kann beispielsweise wenigstens eine Platte aufweisen, welche während dem Brechvorgang über jeweils einem Teilbereich angeordnet ist.

Die Vorrichtung kann weiterhin eine zweite Haltevorrichtung aufweisen. Die zweite Haltevorrichtung kann ähnlich wie die erste Haltevorrichtung 311 ausgebildet sein. Die zweite Haltevorrichtung ist dazu ausgebildet, einen dritten Teil der Substrat-Karte 100 während eines zweiten Brechvorgangs zum Vereinzeln der Substrate 101, 102, 103, 104, 105, 106 auf der Auflagefläche 300 zu halten. In einem Brechvorgang zum Entfernen der Randbereiche wurden beispielsweise die Randbereiche 111 entfernt und in einem ersten Brechvorgang zum Vereinzeln der Substrate 101, 102, 103, 104, 105, 106 das erste und vierte Substrat 101, 104 (erster Teilbereich) und das dritte und sechste Substrat 103, 106 (zweiter Teilbereich), welche zusammen den zweiten Teil der Substrat-Karte 100 bilden, von dem zweiten und fünften Substrat 102, 105, welche den ersten Teil der Substrat-Karte 100 bilden, getrennt. Jedoch sind beispielsweise jeweils das erste Substrat 101 mit dem vierten Substrat 104, das zweite Substrat 102 mit dem fünften Substrat 105 und das dritte Substrat 103 mit dem sechsten Substrat 106 noch miteinander verbunden. In einem weiteren Brechvorgang zum Vereinzeln der Substrate können somit noch diese verbleibenden Teile voneinander getrennt werden. Der dritte Teil der Substrat-Karte 100, welcher von der zweiten Haltevorrichtung auf der Auflagefläche 300 gehalten wird, unterscheidet sich somit von dem ersten Teil, welcher von der ersten Haltevorrichtung 310 auf der Auflagefläche 300 gehalten wird. Der dritte Teil kann jedoch zumindest teilweise mit dem ersten Teil überlappen. Der dritte Teil kann beispielsweise das erste Substrat 101, das zweite Substrat 102 und das dritte Substrat 103 umfassen.

Die Vorrichtung kann für den zweiten Brechvorgang weiterhin auch eine zweite Brechvorrichtung aufweisen. Die zweite Brechvorrichtung kann der ersten Brechvorrichtung 321 im Wesentlichen entsprechen. Jedoch übt die zweite Brechvorrichtung eine Brechkraft auf einen vierten Teil der Substrat-Karte 100 aus, welcher sich von dem zweiten Teil unterscheidet, auf welchen die erste Brechvorrichtung 321 eine Brechkraft F21 ausübt (vgl. Figuren 4, 6, 7). Beispielsweise kann der vierte Teil der Substrat-Karte 100 das vierte, fünfte und sechste Substrat 104, 105, 106 umfassen. Während also das erste, zweite und dritte Substrat 101, 102, 103 durch die zweite Haltevorrichtung auf der Auflagefläche 300 gehalten werden, wird auf das vierte, fünfte und sechste Substrat 104, 105, 106 durch die zweite Brechvorrichtung eine Brechkraft ausgeübt, so dass auch die verbleibenden Substrate voneinander getrennt werden. Das grundsätzliche Prinzip ist dabei das selbe wie beim ersten Brechvorgang zum Vereinzeln der Substrate 101, 102, 103, 104, 105, 106 welcher unter Bezugnahme auf die Figuren 4 bis 7 beschrieben wurde.

Die Auflagefläche 300 kann beispielsweise Aussparungen aufweisen, in welchen die zweite Brechvorrichtung angeordnet ist. Durch Anheben der zweiten Brechvorrichtung, z.B. Brechleisten, kann eine zweite Brechkraft auf die Unterseite der Substrat-Karte 100 im vierten Teil ausgeübt werden, so dass der vierte Teil angehoben wird und an einer zweiten Bruchkante 132 vom dritten Teil der Substrat-Karte 100 abbricht.

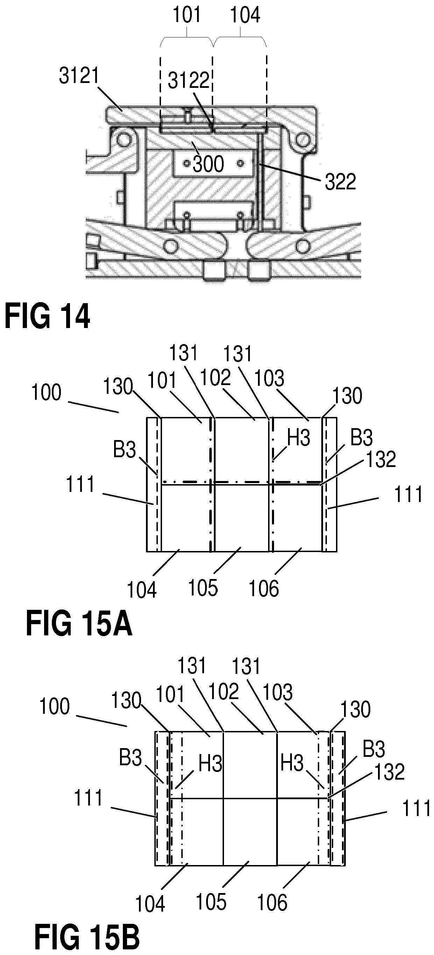

Die Substrat-Karte 100 kann während allen Brechvorgängen auf der Auflagefläche 300 verbleiben. Es ist nicht nötig die Substrat-Karte 100 oder Teile davon zu greifen und umzulegen. Die einzelnen Haltevorrichtungen können nacheinander jeweils für den entsprechenden Brechvorgang auf die Substrat-Karte 100 aufgesetzt werden. Bei jedem Brechvorgang kann die entsprechende Brechvorrichtung eine Brechkraft auf einen Teil der Substrat-Karte 100 ausüben. Während jedem Brechvorgang wirken die entsprechenden Haltekräfte und Brechkräfte auf jeweils unterschiedliche Teile der Substrat-Karte 100. Dies ist in den Figuren 15 bis 17 für drei verschiedene Brechvorgänge beispielhaft dargestellt. In den Figuren 15 bis 17 sind beispielhaft entsprechende Haltebereiche (in strichpunktierten Linien) und Brechbereiche (in gestrichelten Linien) für verschiedene Brechvorgänge dargestellt.

Figur 15 zeigt beispielhaft verschiedene dritte Haltebereiche H3 und verschiedene dritte Brechbereiche B3 während eines dritten Brechvorgangs zum Entfernen von Randbereichen 111. In dem Beispiel in Figur 15 sind zwei Randbereiche 111 auf jeweils gegenüberliegenden Seiten der Substrat-Karte 100 dargestellt. Es ist jedoch ebenso möglich, dass die Substrat-Karte 100 nur auf einer Seite einen Randbereich 111 aufweist. Genauso ist es grundsätzlich auch möglich, dass die Substrat-Karte 100 auf drei oder vier Seiten Randbereiche 111 aufweist.

Bezugnehmend auf Figur 15A, ist der dritte Haltebereich H3 auf einer ersten Seite der dritten Bruchkanten 130 angeordnet. Der dritte Brechbereich B3 verläuft auf der jeweils anderen Seite der dritten Bruchkanten 130. Der dritte Brechbereich B3 befindet sich beispielsweise auf der Seite der dritten Bruchkanten 130, auf welcher sich auch die Randbereiche 111 befinden. Das heißt, es wird eine Bruchkraft auf die Randbereiche 111 ausgeübt. Die dritte Haltekraft F10 wird auf den verbleibenden Teil der Substrat-Karte 100 ausgeübt. In dem Beispiel in Figur 15A verläuft der dritte Haltebereich H3 entlang der ersten, zweiten und dritten Bruchkanten 130, 131, 132 der Substrat-Karte 100. Dadurch können beispielsweise die ersten und zweiten Bruchkanten 131, 132, welche in diesem dritten Brechvorgang nicht gebrochen werden sollen, vor ungewolltem Brechen geschützt werden. Dies ist jedoch lediglich ein Beispiel. Der dritte Haltebereich H3 kann beispielsweise zwei oder mehr Teilbereiche aufweisen, die beispielsweise jeweils entlang einer der dritten Bruchkanten 130 verlaufen, wie beispielsweise in Figur 15B dargestellt. Der dritte Haltebereich H3, bzw. die einzelnen Teilbereiche, können beispielsweise einen Abstand von 0mm bis 1mm, 0mm bis 2,5mm oder 0mm bis 5mm von den entsprechenden dritten Bruchkanten 130 aufweisen. Der dritte Haltebereich H3, bzw. die einzelnen Teilbereiche, können beispielsweise eine Länge aufweisen, die der Länge der entsprechenden dritten Bruchkante 130 entspricht. Der dritte Haltebereich H3, bzw. die einzelnen Teilbereiche, können jedoch auch eine Länge aufweisen, die nur einen Bruchteil der Länge der entsprechenden dritten Bruchkante 130 entspricht. Der dritte Haltebereich H3, bzw. die entsprechenden Teilbereiche, können eine Breite von beispielsweise <1mm, von beispielsweise 1mm bis 5mm, oder >5mm aufweisen. Beispielsweise kann der dritte Haltebereich H3 auch ein einzelner zusammenhängender Bereich sein, welcher sich zwischen den entsprechenden dritten Bruchkanten 130 erstreckt. Gemäß einem Beispiel entspricht die Größe des dritten Haltebereiches H3 der Größe der Substrat-Karte 100 abzüglich der Fläche der Randbereiche 111 und der dritten Bruchkanten 130. In diesem Beispiel wird die Substrat-Karte 100 somit flächig auf der Auflagefläche gehalten.

Der dritte Brechbereich B3 verläuft auf der zweiten Seite der dritten Bruchkanten 130 in einem dritten Abstand zu den dritten Bruchkanten 130. Der dritte Abstand kann beispielsweise 0mm bis 2mm betragen. Der dritte Brechbereich B3 kann im Bereich jedes der Randbereiche 111 eine bestimmte Breite aufweisen, beispielsweise zwischen > 0 mm und < 2mm. So kann die Fläche des dritten Brechbereiches B3 beispielsweise im Wesentlichen der Fläche der Randbereiche 111 entsprechen oder eine kleinere Fläche als die Randbereiche 111 aufweisen.

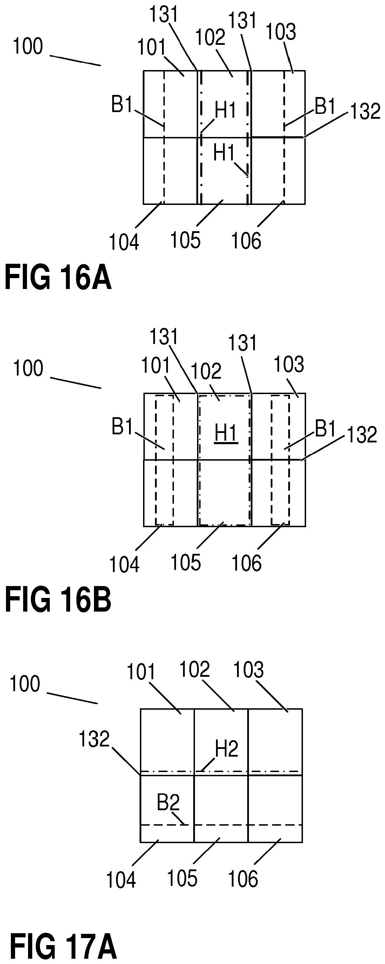

Bezugnehmend auf Figur 16 sind ein erster Haltebereich H1 und ein erster Brechbereich B1 dargestellt. In dem Beispiel in Figur 16 wird die Substrat-Karte 100 in einem ersten Brechvorgang entlang von zwei ersten Bruchkanten 131 gebrochen. Die zwei ersten Bruchkanten 131 verlaufen parallel zueinander. In dem Beispiel in Figur 16 bilden das zweite und das fünfte Substrat 102, 105 einen ersten Teil der Substrat-Karte 100. Das erste, vierte, dritte und sechste Substrat 101, 103, 104, 106, bilden einen zweiten Teil der Substrat-Karte 100, der jedoch wiederum zwei Teilbereiche aufweist. Ein erster Teilbereich umfasst das erste und vierte Substrat 101, 104 und ein zweiter Teilbereich umfasst das dritte und sechste Substrat 103, 106. Der erste und der zweite Teilbereich werden während des ersten Brechvorgangs jeweils von dem ersten Teil abgebrochen. Ein erster Haltebereich H1 verläuft jeweils auf einer Seite der ersten Bruchkanten 131. Ein erster Brechbereich B1 verläuft auf der jeweils anderen Seite der ersten Bruchkanten 131.

Der erste Haltebereich H1 kann wie in Figur 16A dargestellt zwei Teilbereiche aufweisen, welche jeweils in einem schmalen Bereich entlang der ersten Bruchkanten 131 verlaufen. Beispielsweise können die Teilbereiche einen Abstand von 0mm bis 1mm, 0mm bis 2,5mm oder 0mm bis 5mm von den ersten Bruchkanten 131 aufweisen. Die Teilbereiche können beispielsweise eine bestimmte Breite aufweisen, z.B. > 0mm, > 1mm, > 2,5mm oder > 5mm. Der erste Haltebereich H1 kann, wie in Figur 16B dargestellt, auch ein einziger zusammenhängender Bereich sein, dessen Fläche der Fläche des ersten Teils der Substrat-Karte 100 entspricht.

Der erste Brechbereich B1 kann ebenfalls mehrere Teilbereiche aufweisen. Die Anzahl der Teilbereiche des ersten Brechbereiches B1 kann der Anzahl der ersten Bruchkanten 131 entsprechen (hier: zwei). Jeder der Teilbereiche des zweiten Teils der Substrat-Karte 100 kann so vom ersten Teil der Substrat-Karte 100 abgebrochen werden. Jeder der Teilbereiche des ersten Brechbereiches B1 kann einen bestimmten Abstand zu der entsprechenden ersten Bruchkante 131 aufweisen. Der Abstand kann beispielsweise > 0mm, > 1mm, > 2,5mm oder > 5mm betragen. Eine Breite der Teilbereiche des ersten Brechbereiches B1 kann beispielsweise < 1mm, > 1mm, > 2,5mm oder > 5 mm betragen. Ein ersten Brechbereich B1, dessen Teilbereiche eine gewisse Breite aufweisen, sind beispielhaft in Figur 16B dargestellt.

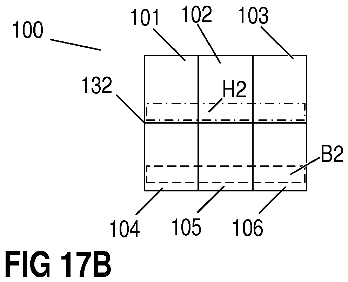

Figur 17 zeigt beispielhaft entsprechende zweite Halte- und Brechbereiche H2, B2. In dem dargestellten Beispiel wird im zweiten Brechvorgang ein Bruch lediglich entlang einer zweiten Bruchkante 132 vorgenommen. Die zweite Bruchkante 132 steht senkrecht zu den ersten Bruchkanten 131. Dies ist jedoch lediglich ein Beispiel. Grundsätzlich können die zweiten Bruchkanten 132 in jedem beliebigen Winkel zu den ersten Bruchkanten stehen. Dadurch können in einem einzigen Schritt das erste Substrat 101 von dem vierten Substrat 104, das zweite Substrat 102 von dem fünften Substrat 105 und das dritte Substrat 103 von dem sechsten Substrat 106 getrennt werden. Der zweite Haltebereich H2 verläuft entlang einer ersten Seite der zweiten Bruchkante 132 und der zweite Brechbereich B2 verläuft auf einer zweiten Seite der zweiten Bruchkante 132. Dabei kann der zweite Haltebereich H2 wiederum ein schmaler Bereich (< 1mm, vgl. Figur 17A) oder ein flächiger Bereich mit einer gewissen Breite (z.B. ≥ 1mm, > 2,5mm, > 5mm) sein (vgl. Figur 17B). Der zweite Haltebereich H2 kann in einem Abstand von beispielsweise 0mm, > 0mm, > 1mm, > 2,5mm oder > 5mm zu der zweiten Bruchkante 132 verlaufen. Der zweite Brechbereich B2 kann ein schmaler Bereich (< 1mm, vgl. Figur 17A) oder ein flächiger Bereich mit einer gewissen Breite (z.B. ≥ 1mm, > 2,5mm, > 5mm) sein (vgl. Figur 17B). Der zweite Brechbereich B2 kann in einem Abstand von beispielsweise > 0mm, > 1mm, > 2,5mm oder > 5mm zu der zweiten Bruchkante 132 verlaufen.

In dem dargestellten Beispiel erfolgt im zweiten Brechvorgang ein Bruch lediglich entlang einer zweiten Bruchkante 132. Dies ist jedoch lediglich ein Beispiel. Es können auch im zweiten Brechvorgang Brüche entlang von mehr als einer zweiten Bruchkante 132 erfolgen. Die dargestellten Brechvorgänge können dabei auch in ihrer Reihenfolge beliebig vertauscht werden. Weiterhin ist ein Brechvorgang zum Entfernen der Randbereiche beispielsweise nicht erforderlich, wenn die Substrat-Karte 100 keine Randbereiche 111 aufweist.

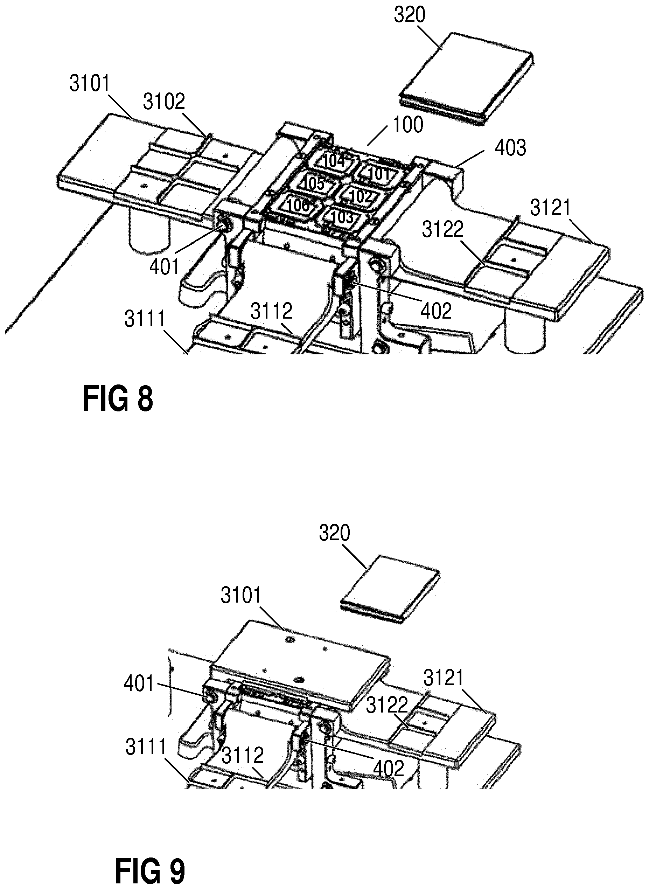

Bezugnehmend auf Figur 8 ist ein Beispiel für eine Vorrichtung zum Brechen von Substraten dargestellt. Eine Substrat-Karte 100 mit beispielsweise sechs Substraten 101, 102, 103, 104, 105, 106 befindet sich auf einer Auflagefläche 300 (in dieser Ansicht vollständig von der Substrat-Karte 100 bedeckt). Auf einer dritten Seite der Auflagefläche 300 ist eine dritte Haltevorrichtung 3101 angebracht. Die dritte Haltevorrichtung 3101 ist beispielsweise mittels einer dritten Verbindungsanordnung 401 mit der Auflagefläche 300 verbunden. Die dritte Haltevorrichtung 3101 kann mittels der dritten Verbindungsanordnung 401 beispielsweise drehbar mit der Auflagefläche 300 verbunden sein, so dass die dritte Haltevorrichtung 3101 bei Bedarf über die Auflagefläche 300 geklappt werden kann. Die dritte Haltevorrichtung 3101 kann beispielsweise dritte Stege 3102 aufweisen, welche entlang der ersten und zweiten Bruchkanten 131, 132 der Substrat-Karte 100 verlaufen, wenn die dritte Haltevorrichtung 3101 auf die Auflagefläche 300 mit der darauf liegenden Substrat-Karte 100 geklappt wurde. Die dargestellten dritten Stege 3102 resultieren in einem Haltebereich ähnlich dem in Figur 15A dargestellten dritten Haltebereich H3. Die dargestellten dritten Stege 3102 sind jedoch lediglich ein Beispiel. Die dritten Stege 3102 können auch flächig ausgebildet sein, so dass daraus ein dritter Haltebereich H3 mit beliebigen wie in Figur 15 beispielhaft beschriebenen Abmessungen resultiert.

Auf einer ersten Seite der Auflagefläche 300 ist eine erste Haltevorrichtung 3111 angeordnet. Die erste Haltevorrichtung 3111 ist beispielsweise mittels einer ersten Verbindungsanordnung 402 mit der Auflagefläche 300 verbunden. Die erste Haltevorrichtung 3111 kann mittels der ersten Verbindungsanordnung 402 beispielsweise drehbar mit der Auflagefläche 300 verbunden sein, so dass die erste Haltevorrichtung 3111 bei Bedarf über die Auflagefläche 300 geklappt werden kann. Die erste Haltevorrichtung 3111 kann beispielsweise erste Stege 3112 aufweisen, welche entlang der ersten Bruchkanten 131 der Substrat-Karte 100 verlaufen, wenn die erste Haltevorrichtung 3111 auf die Auflagefläche 300 mit der darauf liegenden Substrat-Karte 100 geklappt wurde. Die dargestellten ersten Stege 3112 resultieren in einem Haltebereich ähnlich dem in Figur 16A dargestellten ersten Haltebereich H1. Die dargestellten ersten Stege 3112 sind jedoch lediglich ein Beispiel. Die ersten Stege 3112 können auch flächig ausgebildet sein, so dass daraus ein erster Haltebereich H2 mit beliebigen wie in Figur 16 beispielhaft beschriebenen Abmessungen resultiert.

Auf einer zweiten Seite der Auflagefläche ist eine zweite Haltevorrichtung 3121 angeordnet. Die zweite Haltevorrichtung 3121 ist beispielsweise mittels einer zweiten Verbindungsanordnung 403 mit der Auflagefläche 300 verbunden. Die zweite Haltevorrichtung 3121 kann mittels der zweiten Verbindungsanordnung 403 beispielsweise drehbar mit der Auflagefläche 300 verbunden sein, so dass die zweite Haltevorrichtung 3121 bei Bedarf über die Auflagefläche 300 geklappt werden kann. Die zweite Haltevorrichtung 3121 kann beispielsweise zweite Stege 3122 aufweisen, welche wenigstens entlang der zweiten Bruchkante 132 der Substrat-Karte 100 verlaufen, wenn die zweite Haltevorrichtung 3121 auf die Auflagefläche 300 mit der darauf liegenden Substrat-Karte 100 geklappt wurde. Die dargestellten zweiten Stege 3122 resultieren in einem Haltebereich ähnlich dem in Figur 17A dargestellten zweiten Haltebereich H2. Die dargestellten zweiten Stege 3122 sind jedoch lediglich ein Beispiel. Die zweiten Stege 3122 können auch flächig ausgebildet sein, so dass daraus ein zweiten Haltebereich H2 mit beliebigen wie in Figur 17 beispielhaft beschriebenen Abmessungen resultiert.

Dass die Haltevorrichtungen 3101, 3111, 3121 drehbar mit der Auflagefläche 300 verbunden sind ist dabei lediglich ein Beispiel. Die Haltevorrichtungen 3101, 3111, 3121 können beispielsweise auch manuell, mittels eines Roboterarms oder auf jegliche andere geeignete Art und Weise auf die Auflagefläche 300 bzw. die darauf befindliche Substrat-Karte 100 aufgesetzt werden.

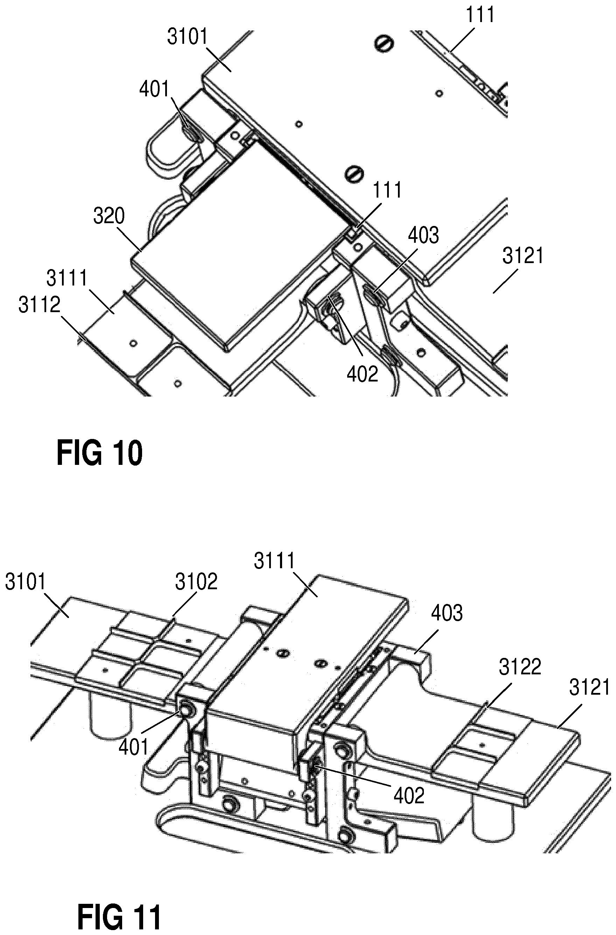

In einem ersten Schritt wird beispielsweise die dritte Haltevorrichtung 3101 auf die Auflagefläche 300 mit der Substrat-Karte 100 aufgesetzt (z.B. geklappt). Dies ist beispielhaft in Figur 9 dargestellt. Wie beispielsweise in Figur 10 dargestellt, ragen vorhandene Randbereiche 111 über die Auflagefläche 300 und die dritte Haltevorrichtung 3101 hinaus. So können die Randbereiche 111 wie unter Bezugnahme auf Figur 3 beschrieben, mittels einer dritten Brechvorrichtung 320 entfernt werden. Die dritte Brechvorrichtung 320 kann dabei beispielsweise manuell oder aber auch maschinell bedient werden.

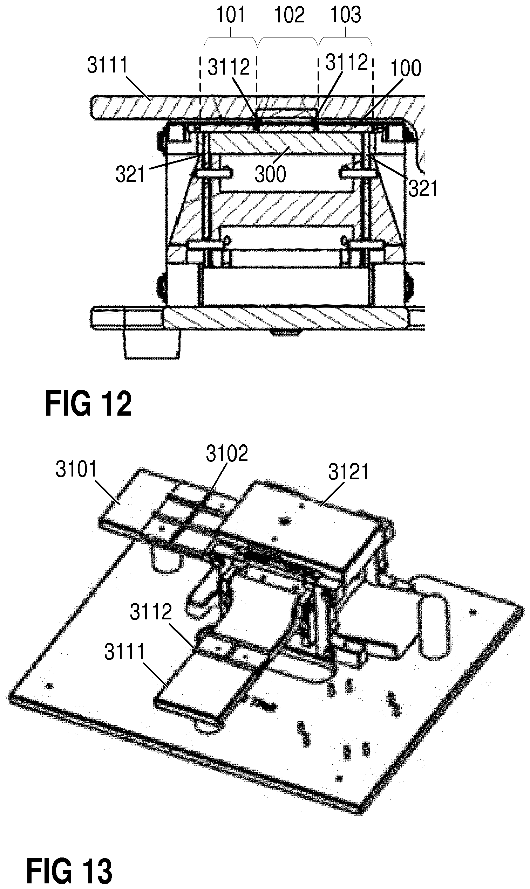

Anschließend wird die dritte Haltevorrichtung 3101 wieder von der Auflagefläche 300 mit der Substrat-Karte 100 entfernt und in einem zweiten Schritt wird, wie in Figur 11 beispielhaft dargestellt, die erste Haltevorrichtung 3111 auf die Auflagefläche 300 mit der Substrat-Karte 100 aufgesetzt (z.B. geklappt). Es können in diesem ersten Brechvorgang, wie unter Bezugnahme auf die Figuren 4, 6 und 7 beschrieben, verschiedene Teile der Substrat-Karte 100 voneinander getrennt werden, wobei jeder Teil wenigstens ein Substrat 101, 102, 103, 104, 105, 106 aufweist. Figur 12 zeigt beispielhaft einen Querschnitt der Anordnung. Während die erste Haltevorrichtung 3111 die entsprechenden Teile (z.B. das zweite und fünfte Substrat 102, 105) der Substrat-Karte 100 hält, werden durch die erste Brechvorrichtung 321 die anderen Teile (z.B. erstes und viertes Substrat 101, 104 und drittes und sechstes Substrat 103, 106) der Substrat-Karte 100 abgebrochen. Die erste Brechvorrichtung 321 kann, wie oben beschrieben, eine Brechkraft auf die Unterseite der Substrat-Karte 100 ausüben, während die erste Haltevorrichtung 3111 die Substrat-Karte 100 von der Oberseite auf der Auflagefläche festhält.

Anschießend kann, wie in Figur 13 beispielhaft dargestellt, die erste Haltevorrichtung 3111 wieder entfernt werden und die zweite Haltevorrichtung 3121 kann auf die Auflagefläche 300 mit der Substrat-Karte 100 aufgesetzt werden. Wie weiter oben bereits beschrieben können so auch noch die verbleibenden Substrate voneinander getrennt werden. Figur 14 zeigt beispielhaft eine zweite Brechvorrichtung die von der Unterseite wiederum eine Brechkraft auf die Substrat-Karte 100 ausübt, während die zweite Haltevorrichtung 3121 die Substrat-Karte 100 von der Oberseite her auf der Auflagefläche 300 hält.

Die erste und die zweite Brechvorrichtung 321, 322 können beispielsweise mechanische Vorrichtungen aufweisen, wie beispielsweise Hebel, Exzenter, elektromagnetische Aktoren oder Hubzylinder. Dabei können während eines Brechvorgangs mehr als zwei Teile voneinander getrennt werden. Beispielsweise können in einem Brechvorgang gleichzeitig zwei oder sogar mehr Brüche erfolgen. Die Brüche können beispielsweise gleichzeitig entlang von parallel zueinander verlaufenden Bruchlinien erfolgen.

Bei der vorliegenden Substrat-Karte 100 mit sechs Substraten 101, 102, 103, 104, 105, 106 sind drei Brechvorgänge ausreichend, um vorhandene Randbereiche 111 zu entfernen und alle Substrate voneinander zu trennen. Während eines Brechvorgangs kann die Substrat-Karte 100 dabei an einer oder an mehreren Bruchkanten 130, 131, 132 gebrochen werden. Bei größeren Substrat-Karten 100 mit mehr Substraten können auch mehr Brechvorgänge erforderlich sein. Jeder der Brechvorgänge kann jedoch nach dem selben grundsätzlichen Prinzip erfolgen, wie es anhand der Figuren beschrieben wurde. Ein Umsetzen der Substrat-Karte 100 in andere Brechvorrichtungen ist während des gesamten Vorgangs nicht erforderlich, unabhängig davon, wie viele Brechschritte (Brechvorgänge) insgesamt erforderlich sind, um alle Substrate voneinander zu trennen.

Merkmale, welche unter Bezugnahme auf eine bestimmte Figur erläutert wurden, können mit Merkmalen anderer Figuren kombiniert werden, sofern nicht anders angegeben. Der Schutzbereich der Patentanmeldung und des Patents wird durch die Patentansprüche bestimmt.

## Patentansprüche

1. Anordnung zum Vereinzeln von Substraten, die Anordnung weist auf:
eine Auflagefläche (300) die dazu ausgebildet ist, eine Substrat-Karte (100) mit einer ersten Oberfläche und einer der ersten Oberfläche gegenüberliegenden zweiten Oberfläche derart aufzunehmen, dass die Substrat-Karte (100) mit ihrer zweiten Oberfläche zumindest teilweise auf der Auflagefläche (300) aufliegt;
eine erste Haltevorrichtung (3111) die dazu ausgebildet ist, eine auf der Auflagefläche (300) angeordnete Substrat-Karte (100) während eines ersten Brechvorgangs auf der Auflagefläche (300) zu halten, wobei die erste Haltevorrichtung (3111) weiter dazu ausgebildet ist, während des ersten Brechvorgangs auf einen ersten Haltebereich (H1) der Substrat-Karte (100) eine erste Haltekraft (F11) auszuüben;
eine erste Brechvorrichtung (321) die dazu ausgebildet ist, während des ersten Brechvorgangs auf einen ersten Brechbereich (B1) der Substrat-Karte (100) eine erste Brechkraft (F21) auszuüben um die Substrat-Karte (100) teilweise zu vereinzeln;
eine zweite Haltevorrichtung (3121) die dazu ausgebildet ist, die nach dem ersten Brechvorgang teilweise vereinzelte Substrat-Karte (100) während eines zweiten Brechvorgangs auf der Auflagefläche (300) zu halten, wobei die zweite Haltevorrichtung (3121) weiter dazu ausgebildet ist, während des zweiten Brechvorgangs auf einen zweiten Haltebereich (H2) der Substrat-Karte (100) eine zweite Haltekraft auszuüben; und
eine zweite Brechvorrichtung (322) die dazu ausgebildet ist, während des zweiten Brechvorgangs auf einen zweiten Brechbereich (B2) der Substrat-Karte (100) eine zweite Brechkraft auszuüben um die Substrat-Karte weiter zu vereinzeln.

2. Anordnung nach Anspruch 1, wobei
die Substrat-Karte (100) wenigstens drei Substrate (101, 102, 103, 104, 105, 106) aufweist;
die Substrat-Karte (100) wenigstens zwei Bruchkanten (131, 132) aufweist, wobei jeder der wenigstens zwei Bruchkanten (131, 132) die Grenze zwischen jeweils zwei Substraten (101, 102, 103, 104, 105, 106) darstellt;
der erste Haltebereich (H1) auf einer ersten Seite wenigstens einer ersten Bruchkante (131) verläuft;
der erste Bruchbereich (B1) auf der jeweils anderen, zweiten Seite der wenigstens einen ersten Bruchkante (131) verläuft;
der zweite Haltebereich (H2) auf einer ersten Seite wenigstens einer zweiten Bruchkante (132) verläuft; und
der zweite Bruchbereich (B2) auf der jeweils anderen, zweiten Seite der wenigstens einen zweiten Bruchkante (132) verläuft.

3. Anordnung nach Anspruch 2, wobei wenigstens eines von
die ersten Bruchkanten (131) in einem Winkel zu den zweiten Bruchkanten (132) angeordnet sind;
der erste Haltebereich (H1) und der erste Bruchbereich (B1) parallel zueinander verlaufen; und
der zweite Haltebereich (H2) und der zweite Bruchbereich (B2) parallel zueinander und senkrecht zu dem ersten Haltebereich (H1) und dem ersten Bruchbereich (B1) verlaufen.

4. Anordnung nach einem der Ansprüche 2 und 3, wobei
der erste Haltebereich (H1) einen ersten Abstand zu der wenigstens einen ersten Bruchkante (131) aufweist;
der erste Bruchbereich (B1) einen zweiten Abstand zu der wenigstens einen ersten Bruchkante (131) aufweist;
der zweite Haltebereich (H2) einen dritten Abstand zu der wenigstens einen zweiten Bruchkante (132) aufweist; und
der zweite Bruchbereich (B2) einen vierten Abstand zu der wenigstens einen zweiten Bruchkante (132) aufweist.

5. Anordnung nach Anspruch 4, wobei
der erste Abstand 0mm, zwischen 0mm und 1mm, zwischen 0mm und 2,5mm oder zwischen 0mm und 5mm beträgt;
der zweite Abstand > 0mm, > 1mm, > 2,5mm oder > 5mm beträgt;
der dritte Abstand 0mm, zwischen 0mm und 1mm, zwischen 0mm und 2,5mm oder zwischen 0mm und 5mm beträgt; und
der vierte Abstand > 0mm, > 1mm, > 2,5mm oder > 5mm beträgt.

6. Anordnung nach einem der vorhergehenden Ansprüche, wobei
die Substrat-Karte (100) eine elektrisch isolierende Schicht (120), eine erste elektrisch leitende Schicht (121) und eine zweite elektrisch leitende Schicht (122) aufweist, wobei die erste elektrisch leitende Schicht (121) eine erste Oberfläche der elektrisch isolierenden Schicht (120) zumindest teilweise bedeckt, und wobei die zweite elektrisch leitende Schicht (122) eine zweite, der ersten Oberfläche gegenüberliegende Oberfläche der elektrisch leitenden Schicht (120) zumindest teilweise bedeckt; und
der erste und der zweite Haltebereich (H1, H2) jeweils nur solche Bereiche der Substrat-Karte (100) aufweisen, in welchen die elektrisch isolierende Schicht (120) nicht von der ersten elektrisch leitenden Schicht (121) bedeckt wird.

7. Anordnung nach einem der Ansprüche 2 bis 6, wobei
die wenigstens drei Substrate (101, 102, 103, 104, 105, 106) eine erste Fläche aufweisen; und
eine Fläche der Auflagefläche (300) genauso groß ist wie die erste Fläche.

8. Anordnung nach einem der vorhergehenden Ansprüche, wobei
die erste Haltevorrichtung (3111) und die zweite Haltevorrichtung (3121) dazu ausgebildet sind, die erste und die zweite Haltekraft (F11) jeweils auf die erste Oberfläche der Substrat-Karte (100) auszuüben; und
die erste Brechvorrichtung (321) und die zweite Brechvorrichtung (322) dazu ausgebildet sind, die erste und die zweite Brechkraft (F21) jeweils auf die zweite Oberfläche der Substrat-Karte (100) auszuüben.

9. Anordnung nach Anspruch 8, wobei
die Auflagefläche (300) erste Aussparungen aufweist die dazu ausgebildet sind die erste Brechvorrichtung (321) aufzunehmen; und
die Auflagefläche (300) zweite Aussparungen aufweist die dazu ausgebildet sind, die zweite Brechvorrichtung (322) aufzunehmen.

10. Anordnung nach einem der vorhergehenden Ansprüche, wobei die erste Brechvorrichtung (321) und die zweite Brechvorrichtung (322) jeweils wenigstens eines aufweisen von
eine Brechleiste,
einen Hebel,
einen Exzenter,
einen elektromagnetischen Aktor, und
einen Hubzylinder.

11. Anordnung nach einem der vorhergehenden Ansprüche, wobei die Substrat-Karte (100) wenigstens auf einer Seite einen Randbereich (111) aufweist, wobei der wenigstens eine Randbereich (111), wenn die Substrat-Karte (100) auf der Auflagefläche (300) aufliegt, zumindest teilweise über die Auflagefläche (300) hinausragt, und wobei die Anordnung weiterhin aufweist
eine dritte Haltevorrichtung (3101) die dazu ausgebildet ist, eine auf der Auflagefläche (300) angeordnete Substrat-Karte (100) während eines dritten Brechvorgangs auf der Auflagefläche (300) zu halten, wobei die dritte Haltevorrichtung (3101) weiter dazu ausgebildet ist, während des dritten Brechvorgangs auf einen dritten Haltebereich (H3) der Substrat-Karte (100) eine dritte Haltekraft (F10) auszuüben; und
eine dritte Brechvorrichtung (320) die dazu ausgebildet ist, während des dritten Brechvorgangs auf einen dritten Brechbereich (B3) der Substrat-Karte (100) eine dritte Brechkraft auszuüben.

12. Anordnung nach Anspruch 11, wobei der dritte Brechbereich (B3) im Bereich des wenigstens einen Randbereiches (111) der Substrat-Karte (100) verläuft.

13. Anordnung nach einem der Ansprüche 11 und 12, wobei die dritte Brechvorrichtung (320) ein bewegliches Element mit einem Schlitz (301) aufweist, wobei der Schlitz (301) dazu ausgebildet ist den wenigstens einen Randbereich (111) während des dritten Brechvorgangs zumindest teilweise aufzunehmen.

14. Verfahren zum Vereinzeln von Substraten, das Verfahren weist auf
Auflegen einer Substrat-Karte (100) auf eine Auflagefläche (300), wobei die Substrat-Karte (100) eine erste Oberfläche und eine der ersten Oberfläche gegenüberliegende zweite Oberfläche aufweist, und wobei die Substrat-Karte (100) derart aufgelegt wird, dass sie mit ihrer zweiten Oberfläche zumindest teilweise auf der Auflagefläche (300) aufliegt;
Ausüben einer ersten Haltekraft (F11) auf einen ersten Haltebereich (H1) der Substrat-Karte (100) während eines ersten Brechvorgangs mittels einer ersten Haltevorrichtung (3111) die dazu ausgebildet ist, die auf der Auflagefläche (300) angeordnete Substrat-Karte (100) während eines ersten Brechvorgangs auf der Auflagefläche (300) zu halten;
Ausüben einer ersten Brechkraft (F21) auf einen ersten Brechbereich (B1) der Substrat-Karte (100) mittels einer ersten Brechvorrichtung (321) die dazu ausgebildet ist, während des ersten Brechvorgangs die Substrat-Karte (100) teilweise zu vereinzeln;
Ausüben einer zweiten Haltekraft auf einen zweiten Haltebereich (H2) der Substrat-Karte (100) während eines zweiten Brechvorgangs mittels einer zweiten Haltevorrichtung (3121) die dazu ausgebildet ist, die nach dem ersten Brechvorgang teilweise vereinzelte Substrat-Karte (100) während eines zweiten Brechvorgangs auf der Auflagefläche (300) zu halten; und
Ausüben einer zweiten Brechkraft auf einen zweiten Brechbereich (B2) der Substrat-Karte (100) mittels einer zweiten Brechvorrichtung (322) die dazu ausgebildet ist, während des zweiten Brechvorgangs die Substrat-Karte (100) weiter zu vereinzeln.

15. Verfahren nach Anspruch 14, wobei die Substrat-Karte (100) wenigstens auf einer Seite einen Randbereich (111) aufweist, wobei der wenigstens eine Randbereich (111), wenn die Substrat-Karte (100) auf der Auflagefläche (300) aufliegt, zumindest teilweise über die Auflagefläche (300) hinausragt, und wobei das Verfahren weiterhin aufweist
Ausüben einer dritten Haltekraft (F10) auf einen dritten Haltebereich (H3) der Substrat-Karte (100) während eines dritten Brechvorgangs mittels einer dritten Haltevorrichtung (3101) die dazu ausgebildet ist, die auf der Auflagefläche (300) angeordnete Substrat-Karte (100) während eines dritten Brechvorgangs auf der Auflagefläche (300) zu halten; und
Ausüben einer dritten Brechkraft auf einen dritten Brechbereich (B3) der Substrat-Karte (100) während des dritten Brechvorgangs mittels einer dritten Brechvorrichtung (320),
wobei der dritte Brechvorgang vor dem ersten Brechvorgang, zwischen dem ersten und dem zweiten Brechvorgang, oder nach dem zweiten Brechvorgang erfolgt.

## Claims

1. Arrangement for separating substrates, which arrangement has:
a support surface (300) which is designed to receive a substrate card (100) having a first surface and a second surface, which is situated opposite the first surface, in such a way that the substrate card (100), by way of its second surface, rests at least partially on the support surface (300);
a first holding apparatus (3111) which is designed to hold a substrate card (100), which is arranged on the support surface (300), on the support surface (300) during a first breaking process, wherein the first holding apparatus (3111) is further designed to exert a first holding force (F11) onto a first holding region (H1) of the substrate card (100) during the first breaking process;
a first breaking apparatus (321) which is designed to exert a first breaking force (F21) onto a first breaking region (B1) of the substrate card (100) during the first breaking process in order to partially separate the substrate card (100);
a second holding apparatus (3121) which is designed to hold the substrate card (100), which was at least partially separated after the first breaking process, on the support surface (300) during a second breaking process, wherein the second holding apparatus (3121) is further designed to exert a second holding force onto a second holding region (H2) of the substrate card (100) during the second breaking process; and
a second breaking apparatus (322) which is designed to exert a second breaking force onto a second breaking region (B2) of the substrate card (100) during the second breaking process in order to further separate the substrate card.

2. Arrangement according to Claim 1, wherein
the substrate card (100) has at least three substrates (101, 102, 103, 104, 105, 106);
the substrate card (100) has at least two break edges (131, 132), wherein each of the at least two break edges (131, 132) represents the border between in each case two substrates (101, 102, 103, 104, 105, 106);
the first holding region (H1) runs on a first side of at least one first break edge (131);
the first break region (B1) runs on the respectively other, second side of the at least one first break edge (131) ;
the second holding region (H2) runs on a first side of at least one second break edge (132); and
the second break region (B2) runs on the respectively other, second side of the at least one second break edge (132).

3. Arrangement according to Claim 2, wherein at least one of
the first break edges (131) are arranged at an angle in relation to the second break edges (132);
the first holding region (H1) and the first break region (B1) run parallel in relation to one another; and
the second holding region (H2) and the second break region (B2) run parallel in relation to one another and perpendicularly in relation to the first holding region (H1) and the first break region (B1).

4. Arrangement according to either of Claims 2 and 3, wherein
the first holding region (H1) is at a first distance from the at least one first break edge (131);
the first break region (B1) is at a second distance from the at least one first break edge (131);
the second holding region (H2) is at a third distance from the at least one second break edge (132); and
the second break region (B2) is at a fourth distance from the at least one second break edge (132).

5. Arrangement according to Claim 4, wherein
the first distance is 0 mm, between 0 mm and 1 mm, between 0 mm and 2.5 mm or between 0 mm and 5 mm;
the second distance is > 0 mm, > 1 mm, > 2.5 mm or > 5 mm;
the third distance is 0 mm, between 0 mm and 1 mm, between 0 mm and 2.5 mm or between 0 mm and 5 mm; and
the fourth distance is > 0 mm, > 1 mm, > 2.5 mm or > 5 mm.

6. Arrangement according to one of the preceding claims, wherein
the substrate card (100) has an electrically insulating layer (120), a first electrically conductive layer (121) and a second electrically conductive layer (122), wherein the first electrically conductive layer (121) at least partially covers a first surface of the electrically insulating layer (120); and wherein the second electrically conductive layer (122) at least partially covers a second surface of the electrically conductive layer (120), which second surface is situated opposite the first surface; and
the first and the second holding region (H1, H2) each have only those regions of the substrate card (100) in which the electrically insulating layer (120) is not covered by the first electrically conductive layer (121).

7. Arrangement according to one of Claims 2 to 6, wherein
the at least three substrates (101, 102, 103, 104, 105, 106) have a first area; and
an area of the support surface (300) is exactly the same size as the first area.

8. Arrangement according to one of the preceding claims, wherein
the first holding apparatus (3111) and the second holding apparatus (3121) are designed to exert the first and the second holding force (F11) in each case onto the first surface of the substrate card (100); and
the first breaking apparatus (321) and the second breaking apparatus (322) are designed to exert the first and the second breaking force (F21) in each case onto the second surface of the substrate card (100).

9. Arrangement according to Claim 8, wherein
the support surface (300) has first cutouts which are designed to receive the first breaking apparatus (321); and
the support surface (300) has second cutouts which are designed to receive the second breaking apparatus (322) .

10. Arrangement according to one of the preceding claims, wherein the first breaking apparatus (321) and the second breaking apparatus (322) each have at least one of
a breaking strip,
a lever,
an eccentric,
an electromagnetic actuator, and
a lifting cylinder.

11. Arrangement according to one of the preceding claims, wherein the substrate card (100) has an edge region (111) at least on one side, wherein the at least one edge region (111), when the substrate card (100) rests on the support surface (300), protrudes at least partially beyond the support surface (300), and wherein the arrangement furthermore has
a third holding apparatus (3101) which is designed to hold a substrate card (100), which is arranged on the support surface (300), on the support surface (300) during a third breaking process, wherein the third holding apparatus (3101) is further designed to exert a third holding force (F10) onto a third holding region (H3) of the substrate card (100) during the third breaking process; and
a third breaking apparatus (320) which is designed to exert a third breaking force onto a third breaking region (B3) of the substrate card (100) during the third breaking process.

12. Arrangement according to Claim 11, wherein the third breaking region (B3) runs in the region of the at least one edge region (111) of the substrate card (100).

13. Arrangement according to either of Claims 11 and 12, wherein the third breaking apparatus (320) has a moving element with a slot (301), wherein the slot (301) is designed to at least partially receive the at least one edge region (111) during the third breaking process.

14. Method for separating substrates, which method comprises
placing a substrate card (100) onto a support surface (300), wherein the substrate card (100) has a first surface and a second surface which is situated opposite the first surface, wherein the substrate card (100) is placed in such a way that it, by way of its second surface, rests at least partially on the support surface (300);
exerting a first holding force (F11) onto a first holding region (H1) of the substrate card (100) during a first breaking process by means of a first holding apparatus (3111) which is designed to hold the substrate card (100), which is arranged on the support surface (300), on the support surface (300) during a first breaking process;
exerting a first breaking force (F21) onto a first breaking region (B1) of the substrate card (100) by means of a first breaking apparatus (321) which is designed to partially separate the substrate card (100) during the first breaking process;
exerting a second holding force onto a second holding region (H2) of the substrate card (100) during a second breaking process by means of a second holding apparatus (3121) which is designed to hold the substrate card (100), which was at least partially separated after the first breaking process, on the support surface (300) during a second breaking process; and
exerting a second breaking force onto a second breaking region (B2) of the substrate card (100) by means of a second breaking apparatus (322) which is designed to further separate the substrate card (100) during the second breaking process.

15. Method according to Claim 14, wherein the substrate card (100) has an edge region (111) at least on one side, wherein the at least one edge region (111), when the substrate card (100) rests on the support surface (300), protrudes at least partially beyond the support surface (300), and wherein the method furthermore comprises
exerting a third holding force (F10) onto a third holding region (H3) of the substrate card (100) during a third breaking process by means of a third holding apparatus (3101) which is designed to hold the substrate card (100), which is arranged on the support surface (300), on the support surface (300) during a third breaking process; and
exerting a third breaking force onto a third breaking region (B3) of the substrate card (100) during the third breaking process means of a third breaking apparatus (320),
wherein the third breaking process takes place before the first breaking process, between the first and the second breaking process, or after the second breaking process.

## Revendications

1. Installation d'individualisation de substrats, l'installation comprenant :
une surface (300) de support, qui est constituée pour recevoir une carte-substrat (100) ayant une première surface et une seconde surface opposée à la première surface de manière à ce que la carte-substrat (100) s'applique par sa seconde surface au moins en partie à la surface (300) de support;
un premier dispositif (3111) de maintien, qui est constitué pour maintenir sur la surface (300) de support pendant une première opération de rupture une carte-substrat (100) disposée sur la surface (300) de support, le premier dispositif (3111) de maintien étant en outre constitué pour appliquer une première force (F11) de maintien pendant la première opération de rupture à une première partie (H1) de maintien de la carte-substrat (100);
un premier dispositif (321) de rupture, qui est constitué pour appliquer une première force (F21) de rupture à une première partie (B1) de rupture de la carte-substrat (100) pendant la première opération de rupture afin d'individualiser en partie la carte-substrat (100);
un deuxième dispositif (3121) de maintien, qui est constitué pour maintenir sur la surface (300) de support pendant une deuxième opération de rupture la carte-substrat (100) individualisée en partie après la première opération de rupture, le deuxième dispositif (3121) de maintien étant constitué en outre pour appliquer une deuxième force de maintien à une deuxième partie (H2) de maintien de la carte-substrat (100) pendant la deuxième opération de rupture, et
un deuxième dispositif (322) de rupture qui est constitué pour appliquer une deuxième force de rupture à une deuxième partie (B2) de rupture de la carte-substrat (100) pendant la deuxième opération de rupture afin de continuer à individualiser la carte-substrat.

2. Installation suivant la revendication 1, dans laquelle
la carte-substrat (100) a au moins trois substrats (101, 102, 103, 104, 105, 106);
la carte substrat (100) a au moins deux bords (131, 132) de rupture, chacun des au moins deux bords (131, 132) de rupture représentant la limite entre respectivement deux substrats (101, 102, 103, 104, 105, 106);
la première partie (H1) de maintien s'étend sur un premier côté d'au moins un premier bord (131) de rupture;
la première partie (B1) de rupture s'étend de respectivement l'autre deuxième côté d'au moins un premier bord (131) de rupture;
la deuxième partie (H2) de maintien s'étend sur un premier côté d'au moins un deuxième bord (132) de rupture et
la deuxième partie (B2) de rupture s'étend de respectivement l'autre deuxième côté du au moins un deuxième bord (132) de rupture.

3. Installation suivant la revendication 2, dans laquelle au moins l'un de
les premiers bords (131) de rupture font un angle avec les deuxièmes bords (132) de rupture;
la première partie (H1) de maintien et la première partie (B1) de rupture s'étendent en étant parallèles entre elles et
la deuxième partie (H2) de maintien et la deuxième partie (B2) de rupture s'étendent en étant parallèles entre elles et en étant perpendiculaires à la première partie (H1) de maintien et à la première partie (B1) de rupture.

4. Installation suivant l'une des revendications 2 et 3, dans laquelle
la première partie (H1) de maintien est à une première distance du au moins un premier bord (131) de rupture;
la première partie (B1) de rupture est à une deuxième distance du au moins un premier bord (131) de rupture;
la deuxième partie (H2) de maintien est à une troisième distance du au moins un deuxième bord (132) de rupture et
la deuxième partie (B2) de rupture est à une quatrième distance du au moins un deuxième bord (132) de rupture.

5. Installation suivant la revendication 4, dans laquelle
la première distance est de 0mm, comprise entre 0mm et 1mm, comprise entre 0mm et 2,5mm ou comprise entre 0mm et 5mm;
la deuxième distance est plus grande que 0mm, plus grande que 1mm, plus grande que 2,5mm ou plus grande que 5mm;
la troisième distance est de 0mm, comprise entre 0mm et 1mm, comprise entre 0mm et 2,5mm ou comprise entre 0mm et 5mm et
la quatrième distance est plus grande que 0mm, plus grande que 1mm, plus grande que 2,5mm ou plus grande que 5mm.

6. Installation suivant l'une des revendications précédentes, dans laquelle
la carte-substrat (100) a une couche (120) isolante du point de vue électrique, une première couche (121) conductrice de l'électricité et une deuxième couche (122) conductrice de l'électricité, la première couche (121) conductrice de l'éectricité recouvrant au moins en partie une première surface de la couche (120) isolante du point de vue électrique et la deuxième couche (120) conductrice de l'électricité recouvrent au moins en partie une deuxième surface, opposée à la première surface, de la couche (120) conductrice de l'électricité, et
la première et la deuxième partie (H1, H2) de maintien ont chacune seulement des parties de la carte-substrat (100) dans lesquelles la couche (120) isolante du point de vue électrique n'est pas recouverte de la première couche (121) conductrice de l'électricité.

7. Installation suivant l'une des revendications 2 à 6, dans laquelle
les au moins trois substrats (101, 102, 103, 104, 105, 106) ont une première surface et
une surface de la surface (300) de support est exactement aussi grande que la première surface.

8. Installation suivant l'une des revendications précédentes, dans laquelle
le premier dispositif (3111) de maintien et le deuxième dispositif (3121) de maintien sont constitués pour appliquer la première et la deuxième force (F11) de maintien respectivement à la première surface de la carte-substrat (100) et
le premier dispositif (321) de rupture et le deuxième dispositif (322) de rupture sont constitués pour appliquer la première et la deuxième force (F21) de rupture respectivement à la deuxième surface de la carte-substrat (100).

9. Installation suivant la revendication 8, dans laquelle
la surface (300) de support a des premiers évidements, qui sont constitués pour recevoir le premier dispositif (321) de rupture, et
la surface (300) de support a des deuxièmes évidements, qui sont constitués pour recevoir le deuxième dispositif (322) de rupture.

10. Installation suivant l'une des revendications précédentes, dans laquelle
le premier dispositif (321) de rupture et le deuxième dispositif (322) de rupture ont chacun au moins l'un de
une baguette de rupture,
un levier,
un excentrique,
un actionneur électromagnétique et
un vérin de levage.

11. Installation suivant l'une des revendications précédentes, dans laquelle
la carte-substrat (100) a au moins d'un côté une partie (111) marginale la au moins une partie (111) marginale dépassant, lorsque la carte-substrat (100) s'applique à la surface (300) de support, au moins en partie de la surface (300) de support, et l'installation a en outre
un troisième dispositif (3101) de maintien, qui est constitué pour maintenir sur la surface (300) de support pendant une troisième opération de rupture une carte-substrat (100) disposée sur la surface (300) de support, le troisième dispositif (3101) de maintien étant constitué pour appliquer une troisième force (F10) de maintien à une troisième partie (H3) de maintien de la carte-substrat (100) pendant la troisième opération de rupture, et
un troisième dispositif (320) de rupture est constitué pour appliquer une troisième force de rupture à une troisième partie (B3) de rupture de la carte-substrat (100) pendant la troisième opération de rupture.

12. Installation suivant la revendication 11, dans laquelle
la troisième partie (B3) de rupture s'étend dans la partie de la au moins une partie (111) marginale de la carte-substrat (100) .

13. Installation suivant l'une des revendications 11 et 12, dans laquelle
le troisième dispositif (320) de rupture a un élément mobile ayant une fente (301), la fente (301) étant constituée pour recevoir au moins en partie une partie (111) marginale pendant la troisième opération de rupture.

14. Procédé d'individualisation de substrats, procédé dans lequel
on met une carte-substrat (100) sur une surface (300) de support, la carte-substrat (100) ayant une première surface et une deuxième surface opposée à la première surface et la carte-substrat (100) étant mise de manière à s'appliquer par sa deuxième surface au moins en partie à la surface (300) de support,
on applique une première force (F11) de maintien sur une première partie (H1) de maintien de la carte-substrat (100) pendant une première opération de rupture au moyen d'un premier dispositif (3111) de maintien, qui est constitué pour maintenir sur la surface (300) de support pendant une première opération de rupture la carte-substrat (100) mise sur la surface (300) de support,
on applique une première force (F21) de rupture à une première partie (B1) de rupture de la carte-substrat (100) au moyen d'un premier dispositif (321) de rupture, qui est constitué pour individualiser au moins en partie la carte-substrat (100) pendant la première opération de rupture,
on applique une deuxième force de maintien à une deuxième partie (H2) de maintien de la carte-substrat (100) pendant une deuxième opération de rupture au moyen d'un deuxième dispositif (3121) de maintien, qui est constitué pour maintenir sur la surface (300) de maintien pendant une deuxième opération de rupture la carte-substrat (100) individualisée en partie après la première opération de rupture et
on applique une deuxième force de rupture à une deuxième partie (B2) de rupture de la carte-substrat (100) au moyen d'un deuxième dispositif (322) de rupture qui est constitué pour continuer à individualiser la carte (100) substrat pendant la deuxième opération de rupture.

15. Procédé suivant la revendication 14, dans lequel la carte (100) substrat a, au moins d'un côté, une partie (111) marginale, la au moins une partie (111) marginale dépassant, lorsque la carte-substrat (100) s'applique à la surface (300) de support, au moins en partie de la surface (300) de support, et dans le procédé, en outre,
on applique une troisième force (F10) de maintien à une troisième partie (H3) de maintien de la carte-substrat (100) pendant une troisième opération de rupture au moyen d'un troisième dispositif (3101) de maintien, qui est constitué pour maintenir sur la surface (300) de support pendant une troisième opération de rupture la carte-substrat (100) mise sur la surface (300) de support, et
on applique une troisième force de rupture à une troisième partie (B3) de rupture de la carte-substrat (100) pendant la troisième opération de rupture au moyen d'un troisième dispositif (320) de rupture,
dans lequel
on effectue la troisième opération de rupture avant la première opération de rupture, entre la première et la deuxième opération de rupture ou après la deuxième opération de rupture.
